# EUROPÄISCHE PATENTSCHRIFT

(11) **EP 2 262 720 B1**
(45) Veröffentlichungstag und Bekanntmachung des Hinweises auf die Patenterteilung: **17.04.2019**
(21) Anmeldenummer: 09720467.1
(22) Anmeldetag: 13.02.2009
(51) Int. Cl.: B81B 7/00

(54) **DECKEL FÜR MIKRO-SYSTEME UND VERFAHREN ZUR HERSTELLUNG EINES DECKELS**
COVER FOR MICROSYSTEMS AND METHOD FOR PRODUCING A COVER
COUVERCLE POUR MICROSYSTÈMES, ET PROCÉDÉ DE PRODUCTION D'UN COUVERCLE

(30) Priorität: 04.03.2008 DE 102008012384
(43) Veröffentlichungstag der Anmeldung: 22.12.2010
(73) Patentinhaber: Fraunhofer-Gesellschaft zur Förderung der angewandten Forschung e.V., 80686 München (DE)
(72) Erfinder: QUENZER, Hans Joachim, 25524 Itzehoe (DE); OLDSEN, Marten, 1160 Wien (AT); HOFMANN, Ulrich, 25524 Itzehoe (DE)
(86) Internationale Anmeldenummer: PCT/EP2009/001024
(87) Internationale Veröffentlichungsnummer: WO 2009/112138

(56) Entgegenhaltungen:
- EP-A2- 1 748 029
- WO-A1-01/38240

## Beschreibung

### Technisches Gebiet

Fertig prozessierte Mikro-Systeme, üblicherweise mikromechanische (MEMS) und mikrooptische Systeme (MOEMS) - wie zum Beispiel Beschleunigungssensoren, Drehratensensoren, Mikrospiegel, bestehen in der Regel aus sehr empfindlichen, zum Teil frei beweglichen Mikrostrukturen (zum Beispiel Balken, Gittern, Platten).

Während der meisten zur Herstellung benötigten Fertigungsschritte (zum Beispiel Schichtabscheidung, Photo-Lithographie, Ätzverfahren) sind auch die beweglichen Mikrostrukturen noch fest und dadurch unbeweglich mit dem Substrat (Trägersubstrat), üblicherweise einem Wafer (Trägerwafer), verbunden. Erst durch einen sogenannten "Release"-Prozess werden diese Mikrostrukturen frei beweglich. Ab diesem Zeitpunkt sind die beweglichen Mikrostrukturen besonders empfindlich, so dass Verunreinigungen oder mechanische Überbeanspruchungen zur Zerstörung oder Funktionseinschränkung dieser Mikrostrukturen und damit zur Dysfunktion des Mikro-Systems führen können. So kommt beispielsweise bei der Vereinzelung eines Wafers, also dem Zersägen eines Wafers in einzelne Chips, die Waferoberfläche und damit die Mikrostrukturen der Mikro-Systeme mit Partikeln und Wasser in Berührung. Des Weiteren können die Mikrostrukturen während eines Sägeprozesses relativ starken mechanischen Belastungen ausgesetzt sein.

Um dennoch Mikro-Systeme mit hoher Ausbeute kostengünstig fertigen zu können, ist man bestrebt, sowohl den "Release"-Prozess als auch Maßnahmen insbesondere zum Schutz der beweglichen Mikrostrukturen bereits durchzuführen, bevor das Trägersubstrat vereinzelt beziehungsweise zerteilt wird.

Eine häufig benutzte Möglichkeit zur Verkapselung von Mikro-Systemen besteht in der Bereitstellung eines entsprechend strukturierten Deckels, der mit dem Trägersubstrat verbunden wird und somit zumindest einen Teil des Gehäuses darstellt.

Die Erfindung betrifft einen Deckel zur Verkapselung von Mikro-Systemen, die insbesondere eine optische Funktion zu erfüllen haben, sowie ein Verfahren zur Herstellung insbesondere eines solchen Deckels, wobei sich das Verfahren auch für die Herstellung von Deckeln eignet, die für eine Verkapselung insbesondere auf Wafer-Ebene, d.h. vor dem Vereinzelungsprozess und damit vor der Zerteilung des Trägersubstrats beziehungsweise des Trägerwafers, verwendbar sind.

### Stand der Technik

Gehäuse zur Verkapselung von Mikro-Systemen, üblicherweise MEMS/MOEMS, sowie Verfahren zur Herstellung solcher Gehäuse insbesondere auf Wafer-Ebene, sogenannte Wafer-Level-Packaging-Verfahren, sind aus der Halbleiterindustrie bekannt.

Wie beispielsweise in der US 6,743,656 beschrieben, wird der Wafer (Trägerwafer) mit den MEMS/MOEMS mit einem weiteren Wafer als Deckel (Deckelwafer), der über geätzte Vertiefungen definierter Abmaße verfügt, verbunden. In der Regel handelt es sich bei den Wafern um Siliziumwafer, so dass auch die Vertiefungen im Deckelwafer mit den bewährten Verfahren der Siliziumtechnologie einfach und präzise hergestellt werden können. Im anschließenden Vereinzelungsprozess, üblicherweise einem Sägeprozess, werden dann separate gekapselte Chips erzeugt, ohne dass Kontaminationsgefahr für die MEMS/MOEMS besteht.

Sollen die MEMS/MOEMS eine optische Funktion ausüben oder sollen bestimmte Parameter oder physikalische Größen der MEMS/MOEMS optisch gemessen werden - beispielsweise Bestimmung der Auslenkung mittels Interferometer oder durch Auswertung von Videosequenzen - dann bedarf es in der Regel eines optisch transparenten Deckels.

In der WO 2004/1068665 wird ein Wafer-Level-Packaging-Verfahren für MOEMS beschrieben, welches einen Deckel aus Glas vorsieht. Vor dem Verkapselungsprozess wird der Trägerwafer mit den MOEMS allerdings vereinzelt. Die daraus resultierenden separaten ungekapselten Chips (DIEs) werden auf einem neuen Substrat platziert, montiert, kontaktiert und erst anschließend gekapselt. Vertiefungen im Deckel können mit bekannten Präge- und Ätzverfahren und/oder durch den Einsatz von Abstandshaltern, zum Beispiel aus Silizium, erzeugt werden.

In der US6146917 wird ein Wafer-Level-Packaging-Verfahren für MEMS/MOEMS beschrieben, bei dem ein mit Vertiefungen versehener Deckelwafer aus Silizium oder Glas durch Fusions-Bonden oder Anodisches Bonden mit dem Trägerwafer verbunden wird, woraus ein hermetisch dichtes Gehäuse resultiert. Die Herstellung der erforderlichen 50 bis 150 µm tiefen Vertiefungen im Deckelwafer aus Silizium kann durch naßchemisches Ätzen mittels KOH-Lösung erfolgen.

In der US2005/0184304 wird ein Wafer-Level-Packaging-Verfahren zur Verkapselung von oberflächenmikromechanisch gefertigten Mikrospiegel-Arrays vorgestellt. Ein Deckelwafer aus Glas besitzt Vertiefungen, die als optische Fenster dienen und auch über entsprechende Vergütungsschichten verfügen können. Die Vertiefungen im Deckelwafer können Tiefen von über 100 µm aufweisen und werden mit gängigen Formgebungsverfahren, wie zum Beispiel Ätzen, Gießen oder Prägen, oder durch den Einsatz von Abstandshaltern erzeugt.

Allen aufgeführten Schriften ist gemein, dass die optischen Fenster des Deckels parallel zur Substratebene des Trägersubstrats (Trägersubstratebene), insbesondere Trägerwafers, und damit zu den darauf angeordneten MEMS/MOEMS ausgeführt sind. Im Stand der Technik werden des Weiteren Deckel mit Vertiefungen, die durch zur Trägersubstratebene geneigt ausgeführte optische Fenster begrenzt sind, beschrieben.

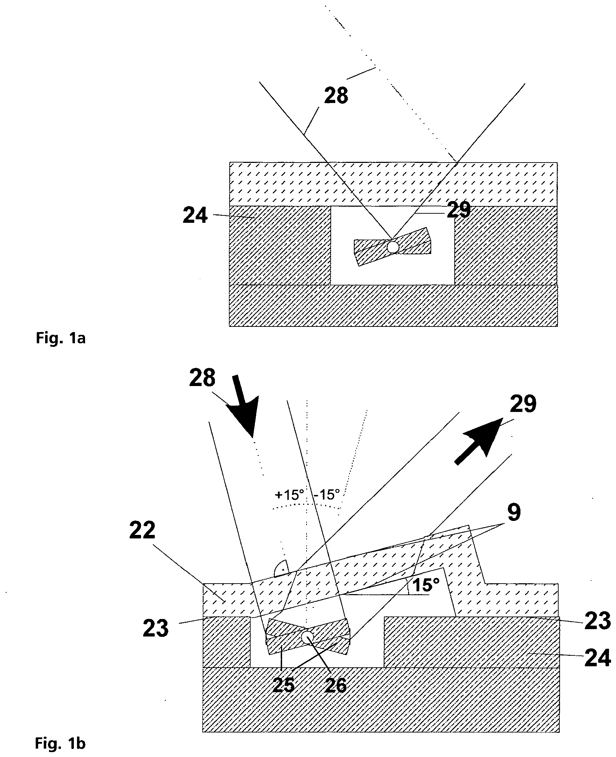

Auf Grund des Brechzahlunterschieds zwischen dem Material der optischen Fenster, meist Glas, und der umgebenden Luft wird ein Anteil der einfallenden Strahlung an den Oberflächen der optischen Fenster (Fig. 1a) reflektiert. Bei verschiedenen optischen Anwendungen, zum Beispiel einem in Bezug auf die Trägersubstratebene kippbar gelagerten Mikrospiegel für Laser-Projektionsverfahren, können unerwünschte Reflexionen an den optischen Fenstern des Deckels die Anwendung störend beeinflussen und beispielsweise die projizierte Bildinformation dauerhaft ortsfest überstrahlen. Reflexionen bereiten insbesondere dann Probleme, wenn sowohl die projizierte Strahlung als auch die Reflexionen unter demselben Winkel auftreten (Fig. 1a). Diese Situation liegt insbesondere dann vor, wenn der genutzte Winkelbereich zum Beispiel des Mikrospiegels eine Position im Arbeitsbereich einnehmen kann, in der die Spiegelfläche des Mikrospiegels parallel zu den optischen Fenstern des Deckels ausgerichtet ist.

An einem optischen Fenster aus Borsilikatglas ohne speziell veredelte Oberflächen werden in der Regel zwischen 4-5 % der senkrecht einfallenden Strahlung reflektiert. Durch die Veredlung der optischen Fenster mit geeigneten Beschichtungen beziehungsweise Schichtsystemen können Reflexionen stark reduziert werden. Während sich für eine eingesetzte Wellenlänge sehr niedrige Reflexionsgrade erreichen lassen, sind diesem Bestreben bei der Verwendung eines breiten Strahlungsspektrums beziehungsweise von Strahlung, die verschiedene Wellenlängenanteile aufweist, naturgemäß Grenzen gesetzt. Eine Reduktion der verbleibenden Reflexionen unterhalb von 0.1 % ist nur mit erheblichem Kostenaufwand möglich.

Im Falle eines einachsigen Mikrospiegels beispielsweise liegt, bedingt durch den vergleichsweise geringen geometrischen Abstand zwischen der Spiegeloberfläche und den Oberflächen der optischen Fenster, zwischen den Reflexionen und der/des projizierten beziehungsweise abgelenkten Strahlung beziehungsweise Strahls nur ein geringer Abstand vor. Der Einsatz von Blendenstrukturen ist daher zwar möglich, erfordert jedoch eine präzise Justage, zumal die einfallende und die projizierte Strahlung üblicherweise einen Durchmesser im Bereich eines Millimeters haben.

Demgegenüber liegen bei einem zweiachsigen Mikrospiegel die Reflexionen in jedem Fall innerhalb des Projektionsbereichs und lassen sich nicht durch einbringen zusätzlicher Strukturen ausblenden.

Entsprechend kann, wie in der WO2007/069165 beschrieben, durch geneigte optische Fenster eine zusätzliche Verringerung der in den Projektions- beziehungsweise Bildbereich fallenden Reflexionen erreicht werden.

In der US2006/0176539A1 ist für die Verkapselung auf Chip-Ebene eine Deckel-Geometrie beschrieben, bei der durch die Neigung der optischen Fenster in Bezug auf die Trägersubstratebene und damit in Bezug auf die Spiegelfläche des Mikrospiegels eine Trennung von Reflexions- und Projektionsbereich (Reflexionsausblendung) erreicht wird. Eine Verwendung des beschriebenen Deckels zur Verkapselung von MEMS/MOEMS auf Wafer-Ebene ist nicht praktikabel. Die Vertiefungen im Deckel werden durch übliche Ätzverfahren erzeugt.

Eine Weiterentwicklung wird in der US2007/0024549A1 beschrieben, wonach ein Deckel eine mit einer Vertiefung versehene Deckeleinheit aufweist, dessen Vertiefung durch mindestens ein optisches Fenster begrenzt ist. Danach können auch Deckel gefertigt werden, die eine Verkapselung auf Wafer-Ebene ermöglichen. Die Formgebung des Deckels beziehungsweise die Realisierung der erforderlichen Vertiefungen erfolgt mit bekannten Präge- und Formgebungsverfahren.

Zu solchen Formgebungsverfahren zählen beispielsweise das Glastiefziehen und das Blankpressen. Insbesondere das Bankpressen wird auch zur Herstellung optischer Komponenten, wie zum Beispiel Linsen, eingesetzt; (siehe Bernd Bresseler, "Mikroproduktion - Der Werkzeugbau als Maß der Dinge" auf der Internetseite http://www.aixtooling.delindex.html?content=/deutsch/aktuelles/aktuelles.html sowie John Deegan Rochester Precision Optics "Precision Glass Molding Technical Brief" auf der Internetseite http://www.rpoptics.com/Precision%20Glass%20Molding%20Technica/%20Brief_2.pdf)*.* Optische Komponenten, die ebene beziehungsweise planparallelen Flächen aufweisen, wie zum Beispiel Spiegel beziehungsweise teildurchlässige Spiegel sowie Strahlteiler (Druckschriften Chuan Pu, Zuhua Zhu and Yu-Hwa Lo "Surface Micromachined Integrated Optic Polarization Beam Splitter"; IEEE PHOTONICS TECHNOLOGY LETTERS, Vol. 10, NO. 7, JULY 1998 sowie Lih Y. Lin and Evan L. Goldstein "Micro-Electro-Mechanical Systems (MEMS) for WDM Optical-Crossconnect Networks", IEEE 1999) werden in der Mikrosystemtechnik üblicherweise aus Silizium hergestellt. So lassen sich beispielsweise durch anisotrope nasschemische Ätzprozesse, zum Beispiel mittels KOH, geneigte Spiegel realisieren (Druckschrift Jenq-Yang Chang, Chih-Ming Wang, Chien-Chieh Lee, Hsi-Fu Shih and Mount-Learn Wu "Realization of Free-Space Optical Pickup Head With Stacked Si-Based Phase Elements"; IEEE PHOTONICS TECHNOLOGY LETTERS). In der Druckschrift Kyounggsik Yu, Daesung Lee, Uma Krishnamoorthy, Namkyoo Park and Olav Solgaard " Micromachined Fourier transform spectrometer on silicon optical bench platform"; Sensors and Actuators A130-131 (2006) 523-530 werden mikrooptische Strahlteiler und geneigte Spiegel ebenfalls mittels verschiedener Ätzverfahren hergestellt, wobei auf eine hohe Qualität, insbesondere auf eine geringe Rauigkeit, der optisch funktionalen Oberflächen verwiesen wird. Mittels nasschemischer KOH-Ätzung lassen sich in Silizium Oberflächen mit einer quadratischen Oberflächenrauigkeit kleiner 20 nm erreichen. Allerdings können solche Oberflächen in Standardsiliziumwafern nur mit bestimmten Neigungswinkeln, die durch die Kristallstuktur von Silizium vorgegeben sind, realisiert werden.

Die Herstellung entsprechender optischer Komponenten auf Basis von Glas, wie zum Beispiel Borsilikatglas, mittels Ätzverfahren führt in der Regel zu Oberflächen, deren Rauigkeit für optische Anwendungen nicht zufriedenstellend ist (siehe Druckschriften Xinghua Li, Takashi Abe, Masayoshi Esashi "Deep reactive ion etching of Pyrex glass using SF6 plasma", Sensors and Actuators A87, 2001, pp. 139-145 sowie Ciprian Iliescu, Kwong Luck Tan, Francis E. H. Tay, Jianmin Miao "Deep Wet and Dry Etching of Pyrex Glass: A Review").

In der WO01/38240A1 wird ein Verfahren zur Herstellung von mikromechanischen und mikrooptischen Bauelementen aus glasartigen Materialien beschrieben, wobei die Strukturierung der Oberflächen unter Ausnutzung der Fließeigenschaften des Glases erfolgt, wodurch qualitativ hochwertige Oberflächen realisiert werden können. Das Verfahren beinhaltet folgende Schritte:
- bereitstellen eines ersten Substrats
- Bereitstellen eines zweiten Substrats,
- in Kontakt bringen des zweiten Substrats mit dem ersten Substrat,
- Erwärmen und Verformen des ersten Substrats derart, dass er sich verschiebt und/oder neigt.

### Beschreibung

Der vorliegenden Erfindung liegt daher die Aufgabe zugrunde, die Nachteile des Standes der Technik zu überwinden und einen Deckel zur Verfügung zu stellen, der den zu verkapselnden Mikro-Systemen genügend Raum und/oder Bewegungsfreiheit sowie eine möglichst geringe störende Beeinflussung der transmittierten Strahlung gewährleistet. Des Weiteren besteht die Aufgabe in der Bereitstellung eines Verfahrens zur Herstellung eines erfindungsgemäßen Deckels beziehungsweise zur Herstellung optischer Komponenten mit verschobenen und/oder geneigten Bereichen und hoher Oberflächenqualität.

Gemäß der vorliegenden Erfindung wird die Aufgabe durch einen Deckel gemäß Anspruch 1 gelöst. Anspruch 18 gibt ein Verfahren zur Herstellung optischer Komponenten insbesondere eines erfindungsgemäßen Deckels an.

Die Unteransprüche lehren vorteilhafte Weiterbildungen; die Ansprüche 46 bis 47 geben vorteilhafte Verwendungen an.

Ein Deckel zur Verkapselung von Mikro-Systemen soll in der Regel mindestens einen Schutz gegen Verunreinigungen bieten und gleichzeitig die mechanische und/oder optische Funktionalität der Mikro-Systeme nicht beeinträchtigen. Sollte die Funktionalität der Mikro-Systeme nicht nur auf Bewegungen in der beziehungsweise parallel zur Trägersubstratebene beschränkt sein, sondern auch Bewegungen senkrecht zur Trägersubstratebene vorsehen, muss ein Deckel den Mikro-Systemen üblicherweise entsprechende Bewegungsfreiheit gewährleisten.

Ein erfindungsgemäßer Deckel für Mikro-Systeme weist ein oder mehrere Deckeleinheiten auf oder besteht daraus, wobei mindestens eine Deckeleinheit mindestens eine durch Verformung bedingte erste Vertiefung aufweist, die zumindest teilweise durch mindestens ein optisches Fenster, dessen quadratische Oberflächenrauigkeit kleiner gleich 25 nm ist, begrenzt ist.

Der erfindungsgemäße Deckel dient der Abdeckung beziehungsweise Verkapselung von Mikro-Systemen, die bevorzugt Ausdehnungen im Millimeter-, Mikrometer- und/oder Nanometerbereich aufweisen. Im Sinne der Erfindung werden unter Mikro-Systemen insbesondere mikromechanische Systeme (MEMS), mikrooptische (MOEMS) Systeme und/oder Mikro-Bauelemente verstanden.

Unter einer Deckeleinheit wird erfindungsgemäß ein Deckel oder der Teil eines Deckels verstanden, der die kleinste zur Verkapselung benötigte Einheit darstellt. In der Halbleitertechnik beispielsweise bezeichnet man die kleinste zu verkapselnde Einheit als DIE, wobei ein DIE üblicherweise durch Zersägen eines Wafers gewonnen wird. Entsprechend würde eine Deckeleinheit ein DIE verkapseln. Insbesondere auf Wafer-Ebene werden häufig Deckel verwendet, die mehrere Deckeleinheiten aufweisen beziehungsweise aus mehreren Deckeleinheiten bestehen. Daher setzt sich der erfindungsgemäße Deckel bevorzugt aus mehreren Deckeleinheiten, insbesondere einem zweidimensionalen Array von Deckeleinheiten, zusammensetzen. Durch Verbinden des Deckels mit dem Trägersubstrat können so eine Vielzahl von Mikro-Systemen gleichzeitig verkapselt werden. Im folgenden Separationsschritt, zum Beispiel einem Sägeschritt, werden die einzelnen verkapselten Bereiche des Trägersubstrats getrennt, wobei entsprechend der Deckel ebenfalls in die einzelnen Deckeleinheiten zerteilt wird. Entsprechend ist der erfindungsgemäße Deckel vorzugsweise einstückig ausgeführt und weist entsprechend keine Fügestellen auf, die sich aus einem stoffschlüssigen, kraftschlüssigen und/oder formschlüssigen Verbindungsprozess mehrerer Teile ergeben. Durch den Wegfall der Verbindungs- und Justageprozesse lassen sich Aufwand und Kosten sparen. Auf den Deckel aufgebrachte Veredlungsschichten bedingen keine Abweichung von der Einstückigkeit.

Bevorzugt weist der Deckel, insbesondere jede Deckeleinheit, Kontaktflächen auf. Kontaktflächen sind bestimmte Flächen des Deckels, die eine stabile Verbindung zwischen Trägersubstrat und Deckel gewährleisten sollen. Vorzugsweise sind die Kontaktflächen des Deckels derart ausgeführt, dass sie eine hermetisch dichte Verbindung mit dem Trägersubstrat und damit eine gegenüber der Umgebung hermetisch dichte Verkapselung ermöglichen. Durch eine hermetisch dichte Verkapselung lässt sich eine Kontamination und eine daraus resultierende Zerstörung beziehungsweise Funktionseinschränkung der Mikro-Systeme besonders effektiv verhindern. Zudem ermöglicht eine solche Verkapselung die Einstellung einer bestimmten Atmosphäre innerhalb der Verkapselung. Zu diesem Zweck sind die Kontaktflächen besonders bevorzugt rahmenförmig angeordnet, so dass sie nach dem in Kontakt bringen mit dem Trägersubstrat die zu verkapselnden Mikro-Systeme umschließen. Vorzugsweise wird mit einer Deckeleinheit nur ein Mikro-System verkapselt. In manchen Fällen kann aber die Notwendigkeit bestehen, mehrere Mikro-Systeme mit einer Deckeleinheit zu verkapseln.

Mindestens eine Deckeleinheit, bevorzugt jede Deckeleinheit, weist mindestens eine durch Verformung bedingte erste Vertiefung auf. Dadurch kann für die Verkapselung benötigter Raum, zum Beispiel aufgrund der Ausdehnungen und/oder der Bewegungen der Mikro-Systeme, zur Verfügung gestellt werden. Insbesondere kann die erste Vertiefung den Mikro-Systemen - deren Funktionalität nicht nur auf Bewegungen in der beziehungsweise parallel zur Trägersubstratebene beschränkt ist, sondern auch Bewegungen senkrecht zur Trägersubstratebene vorsieht - entsprechende Bewegungsfreiheit gewährleisten.

Die erste Vertiefung ist nicht durch Abtrag von Material, insbesondere Deckelmaterial, und damit beispielsweise nicht durch einen Ätzschritt bedingt. Im Gegensatz zu trocken geätzten Vertiefungen, zum Beispiel in Glas, weisen die die erste Vertiefung begrenzenden Flächen (Begrenzungsflächen) eine geringere quadratische Oberflächenrauigkeit auf. Daraus resultiert eine geringe Beeinflussung der transmittierten Strahlung durch den Deckel, was insbesondere für optische Anwendungen von Vorteil ist.

Zudem kann die erste Vertiefung im Vergleich zu isotrop geätzten Vertiefungen, bei denen die quadratische Oberflächenrauigkeit der Begrenzungsflächen mit zunehmender Tiefe der Vertiefung größer wird, Aspektverhältnisse von maximaler Tiefe der Vertiefung zu maximaler Breite der Vertiefung von größer gleich 0,5 aufweisen. Dadurch sind bei gleicher Tiefe geringere laterale Abmaße der ersten Vertiefung möglich.

Ein weiterer Vorteil der ersten Vertiefung gegenüber geätzten Vertiefungen besteht darin, dass maximale Tiefen größer gleich der maximalen Materialdicke des Deckels möglich sind. Dadurch lassen sich Material und Kosten sparen, da bei gleicher geforderter Tiefe ein weniger dickes Ausgangssubstrat für den Deckel erforderlich ist.

Die erste Vertiefung ist zumindest teilweise durch mindestens ein optisches Fenster, dessen quadratische Oberflächenrauigkeit kleiner gleich 25 nm ist, begrenzt. Durch die geringe quadratische Oberflächenrauigkeit der optischen Fenster wird durch den Deckel transmittierte elektromagnetische Stahlung weniger gestreut, weshalb der erfindungsgemäße Deckel insbesondere für optische Anwendungen geeignet ist. Besonders bevorzugt wird die erste Vertiefung durch Flächen begrenzt, die dieselbe quadratische Oberflächenrauigkeit wie das optische Fenster aufweisen. Dadurch lässt sich eine Kontamination der verkapselten Mikro-Systeme durch vom Deckel, zum Beispiel durch mechanische Belastungen, freigesetzte beziehungsweise abbrechende Partikel reduzieren.

Bevorzugt weist jede Deckeleinheit ein oder mehrere optische Fenster auf.

Besonders bevorzugt weist der erfindungsgemäße Deckel ein zweidimensionales Array optischer Fenster auf. So lassen sich mit einem Deckel eine Vielzahl von Mikro-Systemen, insbesondere die Mikro-Systeme eines gesamten Wafers, in nur einem Verkapselungsschritt gleichzeitig verkapseln, was Zeit- und Kostenersparnis bedeutet.

Unter einem optischen Fenster wird erfindungsgemäß ein Bereich des erfindungsgemäßen Deckels verstanden, der für beliebige Wellenlängen und/oder Wellenlängenbereiche elektromagnetischer Strahlung - bevorzugt die durch das zu verkapselnde Mikro-System zu verarbeitende Strahlung und damit die in der Anwendung eingesetzte Strahlung - aus dem infraroten, für den Menschen sichtbaren (Licht) und dem ultravioletten Wellenlängenbereich durchlässig, insbesondere transparent, ist und zudem hohe Qualitätsanforderungen insbesondere an die Oberflächenrauigkeit, die Ebenheit und die Planparallelität erfüllt. Des Weiteren sollten diese Bereiche vorzugsweise eine homogene Materialstruktur aufweisen, um unerwünschte Brechungen und/oder Ablenkungen der Strahlung zu vermeiden.

Die Oberflächen des optischen Fensters, durch die die in der Anwendung eingesetzte Strahlung in das optische Fenster einfällt und/oder wieder ausgekoppelt wird, stellen die Transmissionsflächen des optischen Fensters dar.

Ein Parameter zur Beurteilung der Oberflächenqualität ist die quadratische Oberflächenrauigkeit. Diese sollte bei den optischen Fenstern möglichst gering sein. Um den hohen Qualitätsanforderungen an die Oberflächenrauigkeit gerecht zu werden, weist das mindestens eine optische Fenster, insbesondere dessen Transmissionsflächen, eine quadratische Oberflächenrauigkeit kleiner gleich 25 nm auf. Bevorzugt weist das mindestens eine optische Fenster, insbesondere dessen Transmissionsflächen, eine quadratische Oberflächenrauigkeit kleiner gleich 15 nm, besonders bevorzugt kleiner gleich 5 nm auf.

Dadurch lässt sich die durch den Deckel verursachte Streuung, die beispielsweise zu einer Verringerung des Kontrastverhältnisses beziehungsweise des Signal/Rausch-Abstands des transmittierten optischen Signals führen kann, reduzieren.

Bevorzugt ist das mindestens eine optische Fenster verschoben, insbesondere aus der Deckelbasisebene parallel verschoben, und/oder geneigt in Bezug auf die Deckelbasisebene angeordnet. Dadurch lassen sich die optischen Fenster in nahezu beliebigen Abständen und/oder Neigungswinkeln zu den zu verkapselnden Mikro-Systemen anordnen, was den Deckel flexibel einsetzbar macht. So kann durch verschobene optische Fenster dem zu verkapselnden Mikro-System ohne den Einsatz zusätzlicher Schichten oder Strukturen als Abstandshalter die geforderte Bewegungsfreiheit gewährt werden.

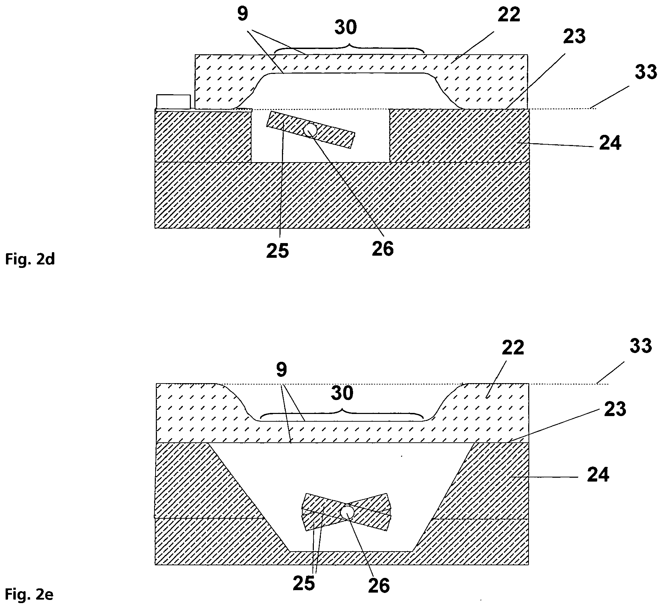

Die Deckelbasisebene wird dabei durch die Kontaktflächen (Fig. 2d) oder durch die den Kontaktflächen gegenüberliegenden, insbesondere parallel gegenüberliegenden, Flächen (Fig. 2e) des Deckels definiert. Nach dem Verbinden des Deckels mit dem Trägersubstrat sind die Trägersubstratebene und die Deckelbasisebene üblicherweise parallel angeordnet.

Vorzugsweise dient der erfindungsgemäße Deckel zur Verkapselung mindestens eines in Bezug auf die Trägersubstratebene kippbar gelagerten Mikrospiegels, wobei mindestens eines der optischen Fenster nach Verbinden des Deckels mit dem Trägersubstrat in Bezug auf die Trägersubstratebene geneigt ausgeführt ist. Vorzugsweise sind alle optischen Fenster des erfindungsgemäßen Deckels geneigt in Bezug auf die Deckelbasisebene und damit nach dem in Kontakt bringen beziehungsweise nach dem Verbinden des Deckels mit dem Trägersubstrat geneigt in Bezug auf die Trägersubstratebene ausgeführt. Durch ein geneigtes optisches Fenster kann beispielsweise bei einem kippbar gelagerten Mikrospiegel eine Trennung von Reflexions- und Projektionsbereich (Reflexionsausblendung) erreicht werden, wodurch sich eine störende Beeinflussung der projizierten Strahlung beziehungsweise des projizierten Signals durch reflexionsbedingte Überstrahlungen reduzieren oder verhindern lässt. Vorzugsweise ist der Neigungswinkel mindestens eines in Bezug auf die Trägersubstratebene geneigten optischen Fensters größer als der maximale Kippwinkel des Arbeitsbereichs des in Bezug auf die Trägersubstratebene kippbar gelagerten Mikrospiegels. Weist der Mikrospiegel beispielsweise einen Arbeitsbereich des Kippwinkels zwischen -15° und +15° auf und ist das geneigte optische Fenster um 15° in Bezug auf die Spiegelfläche des nicht ausgelenkten Mikrospiegels und damit in Bezug auf die Trägersubstratebene geneigt, so werden die Reflexionen der unter 15° in Bezug auf die Flächennormale der Trägersubstratebene und damit senkrecht auf das geneigte optische Fenster treffenden Strahlung in Einfallsrichtung zurückgesandt und fallen somit nicht in den Projektionsbereich, wie man der Fig. 1b entnehmen kann. Durch die Neigung des einfallenden Strahls um 15° in Bezug auf die Flächennormale der Trägersubstratebene und einen Arbeitsbereich des Mikrospiegels zwischen -15° und +15° in Bezug auf die Trägersubstratebene entsteht das projizierte Bild in einem optischen Winkelbereich zwischen +15° und -45°. Damit umfasst der Projektionsbereich einen optischen Winkelbereich (Scanbereich) von fast 60°. Entsprechend ist der Neigungswinkel des geneigten optischen Fensters bevorzugt größer gleich 15°.

Vorzugsweise besteht der erfindungsgemäße Deckel aus einem Material oder einer Materialzusammensetzung, das/die einen thermischen Ausdehnungskoeffizienten aufweist, der sich möglichst geringfügig vom thermischen Ausdehnungskoeffizienten des Trägersubstrats unterscheidet. Dadurch lassen sich thermisch induzierte mechanische Spannungen, die besonders prägnant bei größeren Unterschieden zwischen Verfahrens- und Umgebungs- beziehungsweise Betriebstemperatur - wie das beim anodischen und thermischen Bonden der Fall ist - auftreten können, zwischen Trägersubstrat und Deckel verringern und die Gefahr von Schädigungen am Deckel und/oder am Trägersubstrat beziehungsweise den gekapselten Mikro-Systemen reduzieren.

Der erfindungsgemäße Deckel sollte zumindest in Teilbereichen, üblicherweise in seiner Gesamtheit, für die in der Anwendung eingesetzte elektromagnetische Strahlung durchlässig sein. Bei den meisten optischen Anwendungen wird allerdings eine möglichst hohe Transparenz dieser für die in der Anwendung eingesetzte elektromagnetische Strahlung durchlässigen Bereiche gefordert, damit beispielsweise ein Laserstrahl möglichst unbeeinflusst das Mikro-System erreicht.

Entsprechend enthält der erfindungsgemäße Deckel zumindest in Teilbereichen Glas und/oder ein glasähnliches Material, oder der erfindungsgemäße Deckel bestehen aus Glas und/oder einem glasähnlichen Material.

Unter glasähnlichen Materialien werden erfindungsgemäß Stoffe verstanden, die wegen ihrer thermodynamischen Eigenschaften (amorpher Aufbau, Glasübergangstemperatur) Gläsern ähneln, obwohl sich ihre chemische Zusammensetzung von der der Silikatgläser unterscheidet. Als Beispiele seien hier die in der Chemie bekannten Kunstgläser oder organischen Vitroide wie Polymethylmethacrylate (PMMA), Polycarbonat und Polystyrol genannt.

Besonders geeignete Gläser sind Silikatgläser, insbesondere Borsilikatgläser, da Borsilikatgläser sehr chemikalien- und temperaturbeständig sind. Die Temperaturbeständigkeit und Unempfindlichkeit der Borsilikatgläser gegen plötzliche Temperaturschwankungen sind eine Folge ihres geringen Wärmeausdehnungskoeffizienten. Zudem ist der Transmissionsgrad insbesondere im für den Menschen sichtbaren Wellenlängenbereich mit über 90% sehr hoch.

Die maximale Ausdehnung des erfindungsgemäße Deckels ist bevorzugt größer gleich 80 mm, insbesondere größer gleich 150 mm. In einer vorteilhaften Ausführungsform basiert der erfindungsgemäße Deckel auf einem Substrat in Form eines Wafers, zum Beispiel ein Glaswafer, in dem die ersten Vertiefungen vorgesehen sind und der mehrere Deckeleinheiten aufweist. Dadurch lassen sich mit einem Deckel eine Vielzahl von Mikro-Systemem, die beispielsweise auf einem Trägerwafer aus Silizium angeordnet sind, gleichzeitig verkapseln. Bevorzugt weist der Deckel dieselben lateralen Abmaße wie der Trägerwafer auf - entsprechend zum Beispiel 150 mm (6 Zoll), 200 mm (8 Zoll) oder 300 mm (12 Zoll) Waferdurchmesser, wodurch eine Material optimierte und damit effektive Verkapselung gewährleistet werden kann. Der Deckel weist besonders bevorzugt maximale Ausdehnungen größer als 300 mm auf. Dadurch können auch Substrate mit entsprechend großen Ausdehnungen bei gleichzeitiger Gewährleistung einer hohen optischen Qualität des Deckels verkapselt werden.

Vorzugsweise sind die Transmissionsflächen des mindestens einen optischen Fensters eben (planar) und/oder zueinander planparallel ausgeführt.

Um optischen Qualitätsansprüchen gerecht zu werden, weisen die Transmissionsflächen des mindestens einen optischen Fensters des erfindungsgemäßen Deckels bevorzugt eine Ebenheits- und/oder Planparallelitätsabweichung kleiner einem Viertel der Wellenlänge der in der Anwendung eingesetzten elektromagnetischen Strahlung auf, wobei besonders bevorzugt Wellenlängen vom ultravioletten bis in den infraroten Wellenlängenbereich (zum Beispiel zwischen etwa 200 nm und etwa 15 µm) Anwendung finden. Demzufolge sind bei längerwelligem Licht, zum Beispiel mit einer Wellenlänge von 720 nm, Werte für die Ebenheits- und/oder Planparallelitätsabweichung kleiner 180 nm von Vorteil. Bei Verwendung von kürzerwelligem Licht mit Wellenlängen unter 440 nm steigen die Anforderungen an die Transmissionsflächen, so dass Werte für die Ebenheits- und/oder Planparallelitätsabweichung kleiner 110 nm bevorzugt werden. Insbesondere die optischen Fenster des erfindungsgemäße Deckels, die geneigt ausgeführt sind, weisen vorzugsweise eine Ebenheits- und/oder Planparallelitätsabweichung der Transmissionsflächen kleiner einem Viertel der Wellenlänge der bei der Anwendung eingesetzten elektromagnetischen Strahlung auf. Bevorzugt weisen die geneigten optischen Fenster ebenfalls eine Ebenheits- und/oder Planparallelitätsabweichung der Transmissionsflächen kleiner gleich 180 nm, besonders bevorzugt kleiner gleich 110 nm auf.

Optische Fenster, die diese Anforderungen erfüllen, verursachen geringere Abweichungen und eine geringere Strahlaufweitung des optischen Strahlenverlaufs, was zu einer geringeren Verfälschung der optischen Signale führt.

Die Werte für die Ebenheits- und Planparallelitätsabweichung sowie für die quadratische Oberflächenrauigkeit wurden mittels interferometrischer Messmethode bestimmt. Für die Messungen wurde das Weißlicht- und Phaseninterferometer MicroMap 512 der Firma Atos verwendet.

Um die Eigenschaften des erfindungsgemäßen Deckels zu optimieren, ist es von Vorteil, wenn der erfindungsgemäße Deckel - insbesondere die Transmissionsflächen der optischen Fenster, zumindest teilweise mit mindestens einer Veredlungsbeschichtung und/oder funktionalen Oberflächenstrukturen versehen ist.

Bevorzugt eingesetzte Veredlungsbeschichtungen sind Entspiegelungsbeschichtungen, die Reflexionen an dem erfindungsgemäßen Deckel, insbesondere den optischen Fenstern, und damit Strahlungsverluste weiter verringern. Solche Entspiegelungsbeschichtungen lassen sich zum Beispiel durch Schichtsysteme aus Magnesiumfluorid und Titanoxid, oder Siliziumdioxid und Titanoxid realisieren.

Des Weiteren finden bevorzugt Antistatik-Beschichtungen, die ein elektrisches Aufladen des Deckels minimieren, Verwendung.

Ein für Antistatik-Beschichtungen in optischen Anwendungen besonders geeignetes Material ist ITO (Indiumzinnoxid), da es dotiert eine hohe elektrische Leitfähigkeit aufweist und über einen breiten Wellenlängenbereich eine hohe Transparenz aufweist.

Weiterhin kann es vorteilhaft sein, wenn Reflexionsbeschichtungen, zum Beispiel Metallschichten, als Veredlungsbeschichtungen aufgebracht sind, die nach Strukturierung lokal reflektierende Bereiche bilden, zum Beispiel um einen einfallenden Lichtstrahl räumlich zu begrenzen (Blendenfunktion) oder um in Nachbarschaft zu den optischen Fenstern einen statischen Umlenkspiegel zu bilden.

Bevorzugt eingesetzte Veredlungsbeschichtungen sind des Weiteren Absorbtionsbeschichtungen, die elektromagnetische Strahlung bestimmter Wellenlängen oder ganzer Wellenlängenbereiche absorbieren.

Funktionale Oberflächenstrukturen sind im Sinne der Erfindung geometrische Modifikationen der Oberfläche im Mikro- und/oder Nanometerbereich, wodurch bestimmte Oberflächeneigenschaften gezielt beeinflusst werden können. So kann durch den bevorzugten Einsatz von Mottenaugenstrukturen (siehe Druckschrift D.G. Stavenga, S. Foletti, G. Palasantzas, K. Arikawa "Light on the moth-eye corneal nipple array of butterflies", Proceedings of the Royal Society B (2006) 273, 661-667, doi: 10.1098/rspb.2005.3369, Published online 6 December 2005), deren strukturellen Abmaße unterhalb der Wellenlänge der in der Anwendung eingesetzten Strahlung liegen, der Brechungsindex einer Grenzschicht -wie sie zum Beispiel zwischen einer Glasoberfläche und der sie umgebenden Luft besteht - verringert werden, weshalb sich Mottenaugenstrukturen zur Entspiegelung von Oberflächen eignen. Eine solche Enspiegelung ist insbesondere dann von Vorteil, wenn sich eine Beschichtung aus Haftungsgründen als ungeeignet erweist.

Das erfindungsgemäße Verfahren zur Herstellung optischer Komponenten, weist die folgenden Verfahrensschritte auf:
- Bereitstellen eines ersten Substrats,
- Erzeugen eines Stapels durch Aufbringen mindestens einer Schicht auf das erste Substrat,
- Strukturierung der mindestens einen Schicht zur Erzeugung von mindestens einem Verstärkungselement,
- Bereitstellen mindestens eines zweiten Substrats,
- in Kontakt bringen des mindestens einen zweiten Substrats mit dem Stapel,
- Erwärmen und Verformen des ersten Substrats derart, dass sich mindestens ein durch das mindestens eine Verstärkungselement abgedeckter Bereich des ersten Substrats verschiebt und/oder neigt.

Das erfindungsgemäße Verfahren dient der Herstellung optischer Komponenten, bei denen bestimmte Bereiche beziehungsweise Flächen geneigt und/oder verschoben in Bezug auf die Substratebenen ausgeführt sind. Die optische Komponente weist mindestens ein optisches Element wie zum Beispiel ein optisches Fenster, einen Spiegel beziehungsweise teildurchlässigen Spiegel, einen Strahlteiler und/oder einen Interferenzfiltern auf, oder die optische Komponente besteht aus mindestens einem optischen Element. Die optische Komponente ist bevorzugt ein Deckel mit einem oder mehreren optischen Fenstern.

Bevorzugt wird das erfindungsgemäße Verfahren zur Herstellung eines erfindungsgemäßen Deckels nach Anspruch 1 eingesetzt, wobei der erfindungsgemäße Deckel zur Verkapselung von Mikro-Systemen, die insbesondere eine optische Funktion zu erfüllen haben und üblicherweise auf einem Trägersubstrat aufgebracht oder angeordnet sind, geeignet ist. Häufig findet als Trägersubstrat ein Siliziumwafer Anwendung, auf dem durch oberflächenmikromechanische oder volumenmikromechanische Prozesse die zu verkapselnden Mikro-Systeme erzeugt werden.

Das erste Substrat stellt das Ausgangs- beziehungsweise Basissubstrat für die optische Komponente dar. Entsprechend gilt für Material beziehungsweise Materialzusammensetzung und Oberflächeneigenschaften, wie Rauigkeit, Ebenheit, und Planparallelität der Substratebenen, des ersten Substrats das bereits zum erfindungsgemäßen Deckel ausgeführte. Entsprechend sind die beiden Substratseiten des ersten Substrats zur Gewährleistung einer hohen Oberflächenqualität bevorzugt poliert ausgeführt.

Bevorzugt enthält das erste Substrat zumindest in Teilbereichen Glas und/oder ein glasähnliches Material oder das erste Substrat besteht aus Glas und/oder einem glasähnlichen Material. Besonders geeignete Gläser sind Silikatgläser, insbesondere Borsilikatglas.

Im nächsten Schritt wird durch Aufbringen mindestens einer Schicht auf das erste Substrat ein Stapel erzeugt.

Die mindestens eine Schicht kann beispielsweise mittels Abscheideverfahren auf das erste Substrat aufgebracht werden und/oder die mindestens eine Schicht wird durch die Verwendung mindestens eines weiteren Substrats realisiert.

Die mindestens eine Schicht besteht bevorzugt aus einem halbleitenden Material oder enthält bevorzugt zumindest in Teilbereichen ein halbleitendes Material. Besonders bevorzugt finden dafür Siliziumschichten, insbesondere Polysiliziumschichten, und/oder als weiteres Substrat ein Halbleiterwafer, bevorzugt ein Siliziumwafer, Verwendung, um die ausgereiften und gut beherrschbaren Prozesse der Halbleitertechnologie, insbesondere der Siliziumtechnologie, einsetzen zu können.

Beim Aufbringen der mindestens einen Schicht auf das erste Substrat werden das erste Substrat und die mindestens eine Schicht vorzugsweise stoffschlüssig miteinander verbunden, um eine hohe Lagestabilität der mindestens einen Schicht gegenüber dem ersten Substrat zu gewährleisten. Dafür sind generell alle zweckmäßigen Techniken einsetzbar wie zum Beispiel Abscheiden, Kleben, Löten oder Bonden.

Zweckmäßig erfolgt das Aufbringen der mindestens einen Schicht auf das erste Substrat derart, dass ein Verschieben und/oder Verdrehen der mindestens einen Schicht gegenüber dem ersten Substrat reduziert oder verhindert wird.

In einer vorteilhaften Ausgestaltung des Verfahrens wird als mindestens eine Schicht eine Polysiliziumschicht mittels CVD, insbesondere Hot Wire-CVD, auf das erste Substrat aufgebracht. Da die Prozesstemperaturen bei diesem Abscheideverfahren unter 500°C, bevorzugt zwischen 300°C und 400°C, liegen, lassen sich damit auch temperaturempfindlichere Substrate beschichten.

In einer weiteren bevorzugten Ausführungsform wird die mindestens eine Schicht, zum Beispiel ein Siliziumwafer, durch anodisches Bonden und/oder thermisches Bonden auf das erste Substrat aufgebracht beziehungsweise mit diesem verbunden. Vor allem in der Halbleiterindustrie sind diese Bondverfahren häufig eingesetzte Verbindungstechniken, die zu stabilen Verbindungen führen.

Vorzugsweise weist die mindestens eine Schicht zumindest auf der Schichtseite, die mit dem ersten Substrat in Verbindung gebracht wird, mindestens eine zweite Vertiefung auf. Diese zweite Vertiefung soll einen Kontakt zwischen dem ersten Substrat und der mindestens einen Schicht in bestimmten Bereichen des ersten Substrats beim Aufbringen verhindern, um die Oberflächenqualität des ersten Substrats in diesen Bereichen für weitere Verbindungs- und/oder Kontaktierungsschritte zu konservieren. Solche zu konservierenden Bereiche sind insbesondere die Bereiche des ersten Substrats, die nicht mit Verstärkungselementen versehen werden. Die zweiten Vertiefungen in der mindestens einen Schicht weisen bevorzugt Tiefen von etwa 0,5 µm bis etwa 1 µm auf.

Im folgenden Verfahrensschritt erfolgt die Strukturierung der mindestens einen Schicht zur Erzeugung von mindestens einem Verstärkungselement derart, dass eine Verformung der als optische Fenster fungierenden Bereiche des ersten Substrats reduziert oder verhindert wird. Dies wird insbesondere dadurch erreicht, dass die mindestens eine Schicht die als optische Fenster fungierenden Bereiche des ersten Substrats zumindest teilweise bedeckt. Das zusätzliche Material der Verstärkungselemente stabilisiert und schützt die bedeckten Bereiche des ersten Substrats und wirkt einer Verformung entgegen. Dadurch lassen sich die bevorzugt beim bereitgestellten ersten Substrat vorhandene hohe Ebenheit, Planparallelität und geringe Oberflächenrauigkeit erhalten, was die Basis für qualitativ hochwertige optische Fenster ist, und zudem Flächen - insbesondere Transmissionsflächen, die einer nachträglichen Bearbeitung (zum Beispiel einem Polierschritt) nicht zugänglich sind, mit einer hohen Oberflächenqualität realisieren.

Vorzugsweise wird des Weiteren mindestens ein Fixierungselement erzeugt, das nach dem in Kontakt bringen des Stapels mit dem mindestens einen zweiten Substrat ein Verschieben und/oder Verdrehen des mindestens einen Verstärkungselements gegenüber dem ersten Substrat reduziert oder verhindert und damit die Lagestabilität der Verstärkungselemente erhöht. Bevorzugt werden die Fixierungselemente im folgenden Verfahrensschritt des in Kontakt bringens des Stapels mit dem mindestens einen zweiten Substrat zwischen dem Stapel und dem mindestens einen zweiten Substrat eingeklemmt. Durch das Vorsehen von geeigneten Aufnahmenuten - zum Beispiel in dem mindestens einen zweiten Substrat, lässt sich trotz der zwischengelagerten beziehungsweise eingeklemmten Fixierungselemente ein zweckmäßiger Kontakt zwischen Stapel und mindestens einen zweiten Substrat gewährleisten.

Vorzugsweise stehen die Verstärkungselemente und die Fixierungselemente direkt miteinander in Verbindung, um eine möglichst stabile Kraftkopplung gewährleisten zu können.

In einer weiteren bevorzugten Ausführungsform werden ein oder mehrere Auflagestrukturen erzeugt, wobei die Erzeugung der Auflagestrukturen derart erfolgt, dass die Auflagestrukturen die Auflagebereiche, insbesondere die Auflageflächen, des ersten Substrats schützen und/oder als Abstandshalter zwischen dem ersten Substrat und dem mindestens einen zweiten Substrat fungieren.

Die Auflagebereiche sind die Bereiche des ersten Substrats, die während des Verfahrens keine Auslenkung, insbesondere nicht durch Verformung, erfahren beziehungsweise durch das mindestens eine zweite Substrat direkt oder indirekt unterstützt werden. Eine direkte Unterstützung liegt vor, wenn das erste Substrat und das mindestens eine zweite Substrat miteinander in Kontakt gebracht werden. Bei einer indirekten Unterstützung sind beispielsweise zwischen dem ersten Substrat und dem mindestens einen zweiten Substrat Schichten oder Schichtfolgen angeordnet. Die Auflageflächen sind die Oberflächen der Auflagebereiche; insbesondere die Oberflächen, die dem mindestens einen zweiten Substrat zugewandt sind. Bei einem herzustellenden erfindungsgemäßen Deckel bilden vorzugsweise die Auflageflächen des ersten Substrats die Kontaktflächen, und damit die Flächen des erfindungsgemäßen Deckels, die für den Kontakt beziehungsweise die Verbindung des erfindungsgemäßen Deckels mit dem Trägersubstrat vorgesehen sind.

Die Auflagestrukturen werden bevorzugt durch Schichten oder Schichtfolgen, die auf dem ersten Substrat und/oder auf dem mindestens einen zweiten Substrat aufgebracht beziehungsweise angeordnet werden, realisiert. Durch die Variation der Schichtdicken der Schichten oder Schichtfolgen lässt sich der Abstand zwischen dem ersten Substrat und dem mindestens einen zweiten Substrat einstellen, so dass die Auflagestrukturen bevorzugt als Abstandshalter fungieren.

Die mindestens eine Auflagestruktur und/oder das mindestens eine Fixierungselement werden bevorzugt in demselben Verfahrensschritt wie das mindestens eine Verstärkungselement durch die Strukturierung der mindestens einen Schicht, wodurch eine zeitsparende und kostengünstige Fertigung erreicht wird, und/oder in einem oder mehreren zusätzlichen Verfahrensschritt/en vor dem in Kontakt bringen des Stapels mit dem mindestens einen zweiten Substrat, was eine flexible Fertigung ermöglicht, erzeugt. Die Auflagestrukturen und/oder Fixierungselemente gehören, unabhängig von der Art der Erzeugung, zum Stapel.

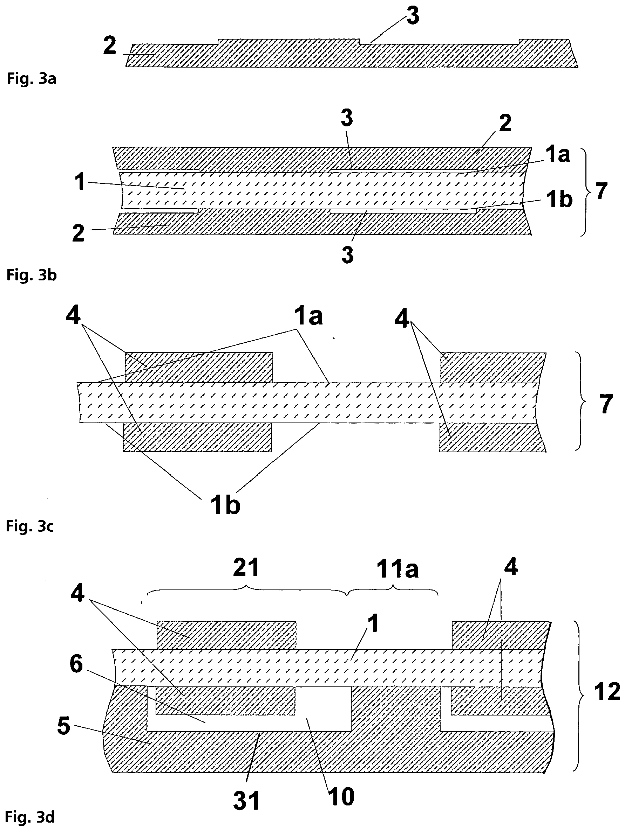

Vorzugsweise wird auf beiden Substratseiten des ersten Substrats jeweils mindestens eines der Verstärkungselemente angeordnet, wobei sich gegenüberliegende Verstärkungselemente bevorzugt zumindest teilweise überlappen. In einer besonders vorteilhaften Ausführungsform überlappen sich solche Verstärkungselemente komplett (Fig. 3c). Dadurch werden die durch sie abgedeckten Bereiche des ersten Substrats besonders gut stabilisiert und vor Verformung geschützt.

Bevorzugt wird mindestens eines der Verstärkungselemente so angeordnet, dass ein Neigen des durch diese/s Verstärkungselement/e abgedeckten Bereiche/s des ersten Substrats beim Erwärmen und Verformen unterstützt wird. Dies wird insbesondere dadurch erreicht, dass mindestens eines der Verstärkungselemente nicht zentrisch im Auslenkungsbereich des ersten Substrats angeordnet wird. Auslenkungsbereiche sind die nicht unterstützten Bereiche des ersten Substrats, die sich zwischen den Auflagebereichen befinden. Ein Auslenkungsbereich lässt sich aufteilen in durch die Verstärkungselemente abgedeckte Bereiche des ersten Substrats und die Verformungsbereiche des ersten Substrats. Die Verformungsbereiche stellen wiederum die Bereiche des ersten Substrats dar, die durch ihre Formänderung ein Auslenken, insbesondere ein Verschieben und/oder Neigen, der durch die Verstärkungselemente abgedeckten Bereiche des ersten Substrats gewährleisten.

Durch eine nicht zentrische Anordnung der Verstärkungselemente im Auslenkungsbereich lässt sich bei einer Gleichverteilung der Kraft über den Verstärkungselementen ein resultierendes Drehmoment erzielen, welches auf die durch die Verstärkungselemente abgedeckten Bereiche des ersten Substrats wirkt, und damit ein Neigen der durch die Verstärkungselemente abgedeckten Bereiche des ersten Substrats begünstigt.

Unter einer nicht zentrische Anordnung eines Verstärkungselements im Auslenkungsbereich wird im Sinne der Erfindung verstanden, dass der Abstand des Verstärkungselements in mindestens einer Richtung nicht zu allen an den Auslenkungsbereich angrenzenden Auflagebereichen gleichgroß ist. Entsprechend gilt für eine nicht zentrische Kraft auf den Auslenkungsbereich, dass der Abstand des Angriffpunkts der Kraft in mindestens einer Richtung nicht zu allen an den Auslenkungsbereich angrenzenden Auflagebereichen gleichgroß ist. Bei einer nicht zentrischen Kraft auf ein Verstärkungselement ist der Abstand des Angriffspunkts zu den Rändern des Verstärkungselements in mindestens einer Richtung nicht gleichgroß.

Nach dem Bereitstellen mindestens eines zweiten Substrats, wird dieses zweite Substrat in Kontakt mit dem Stapel gebracht.

Bevorzugt enthält das mindestens eine zweite Substrat zumindest in Teilbereichen ein halbleitendes Material oder das mindestens eine zweite Substrat besteht aus einem halbleitenden Material. Insbesondere Halbleiterwafer, bevorzugt Siliziumwafer, finden als zweites Substrat Verwendung, wodurch die ausgereiften und gut beherrschbaren Prozesse der Halbleitertechnologie, insbesondere der Siliziumtechnologie, einsetzbar sind.

Das mindestens eine zweite Substrat - insbesondere die Bereiche des mindestens einen zweiten Substrats, die mit dem Stapel in Kontakt gebracht werden - enthält vorzugsweise hochtemperaturbeständige Materialien, insbesondere Graphit, oder besteht daraus. Auf Grund geringer Abnutzung beziehungsweise des geringen Verschleißes lassen sich solche Substrate mehrfach benutzen beziehungsweise wieder verwenden.

Bevorzugt weist das mindestens eine zweite Substrat mindestens eine dritte Vertiefung auf, die vorzugsweise auf der Substratseite des zweiten Substrats ausgebildet ist, die mit dem Stapel in Kontakt gebracht wird. Die dritten Vertiefungen des zweiten Substrats sind bevorzugt zwischen etwa 100 µm und 1000 µm, besonders bevorzugt einige Millimeter, tief, so dass verformungsbedingte Auslenkungen des ersten Substrats und damit insbesondere die Tiefen der ersten Vertiefungen über einen weiten Bereich variierbar sind.

Das in Kontakt bringen des Stapels mit dem mindestens einen zweiten Substrat erfolgt bevorzugt derart, dass durch die dritten Vertiefungen in dem zweiten Substrat und/oder durch die Auflagestrukturen Hohlräume zwischen dem zweiten Substrat und dem Stapel gebildet werden. In einer bevorzugten Ausgestaltung schließen diese Hohlräume die dem zweiten Substrat zugewandten Verstärkungselemente ein.

Durch die Hohlräume kann ein Kontakt zwischen den Verstärkungselementen und dem zweiten Substrat vor dem Erwärmen verhindert werden. Ein Kontakt der Verstärkungselemente und/oder des ersten Substrats in den Auslenkungsbereichen mit dem zweiten Substrat vor dem Erwärmen kann zum Anhaften der Verstärkungselemente und/oder des ersten Substrats an dem zweiten Substrat in den Auslenkungsbereichen führen und ein verformungsbedingtes Auslenken, insbesondere Verschieben und/oder Neigen, der durch die Verstärkungselemente abgedeckten Bereiche des ersten Substrats verhindern oder erschweren.

Des Weiteren kann in den Hohlräumen ein Druck unterhalb oder oberhalb des Umgebungsdrucks, insbesondere des atmosphärischen Luftdrucks, erzeugt werden. Da die Hohlräume zumindest durch Teilbereiche der Auslenkungsbereiche des ersten Substrats begrenzt werden, lassen sich durch einen in den Hohlräumen erzeugten Druck, der unterhalb oder oberhalb des Umgebungsdrucks liegt, Kraftwirkungen zur Begünstigung des Verformungsprozesses erzeugen.

Vorzugsweise entspricht der Umgebungsdruck dem atmosphärischen Luftdruck, und die Druckwerte in den Hohlräumen liegen dann bevorzugt zwischen etwa 750 mbar und etwa 900 mbar oder zwischen etwa 1200 mbar und etwa 1350 mbar und können beispielsweise mittels Vakuumpumpe erzeugt werden.

Des Weiteren kann es von Vorteil sein, wenn das in Kontakt bringen des mindestens einen zweiten Substrats mit dem Stapel zu einer Verbindung, insbesondere einer stoffschlüssigen Verbindung, führt. Dadurch lassen sich bevorzugt von der Umgebung hermetisch dicht abschießende Hohlräume zwischen dem Stapel und dem zweiten Substrat erzeugen. Indem der Verbindungsprozess bei bestimmten Drücken durchgeführt wird, können bestimmte Druckwerte in den Hohlräumen erzeugt werden. Bevorzugt liegen die Druckwerte während des Verbindungsprozesses, zum Beispiel dem anodischen Bonden bei 400°C, zwischen etwa 500 mbar und etwa 600 mbar oder zwischen etwa 800 mbar und etwa 900 mbar. Da der anschließende Erwärmungsprozess typischerweise bei wesentlich höheren Temperaturen als der Verbindungsprozess erfolgt - bevorzugt wird das erste Substrat während des Verfahrensschritts des Erwärmens und Verformens auf eine Temperatur zwischen etwa 750 °C und etwa 900 °C gebracht - ergeben sich durch die höhere Temperatur aus den angegebenen Druckbereichen in den Hohlräumen Drücke von etwa 750 mbar bis etwa 900 mbar oder etwa 1200 mbar bis 1350 mbar. Da die Hohlräume bevorzugt hermetisch dicht von der Umgebung abgeschlossen sind, bleiben diese Druckwerte ohne weitere Energiezufuhr, zum Beispiel zum Betrieb einer Vakuumpumpe, über einen längeren Zeitraum und damit insbesondere für den folgenden Verformungs- beziehungsweise Formgebungsschritt erhalten.

Bevorzugt wird die Verbindung zwischen Stapel und zweitem Substrat durch anodisches Bonden und/oder thermisches Bonden realisiert.

Bei der Formgebung des ersten Substrats werden insbesondere die Fließeigenschaften des ersten Substrats, wie sie insbesondere in der Nähe und oberhalb der Erweichungstemperatur (softening point) und/oder der Schmelztemperatur vorliegen, ausgenutzt. Der Vorteil dieser Art der Formgebung gegenüber anderen Formgebungs- oder Prägeverfahren, wie zum Beispiel Glastiefziehen oder Glasprägen (zum Beispiel Blankpressen), besteht vor allem darin, dass sich insbesondere optische Komponenten beispielsweise mit Substrat- beziehungsweise Waferausdehnungen, insbesondere Substrat- beziehungsweise Waferdurchmessern, größer gleich 80 mm, insbesondere größer gleich 150mm, besonders bevorzugt größer gleich 300mm, mit hoher Oberflächenqualität, insbesondere geringe Oberflächenrauigkeit, hohe Oberflächenebenheit und hohe Planparallelität der Oberflächen, realisieren lassen. Insbesondere wenn das Ausgangssubstrat aus Glas besteht, ist häufig die Oberflächenrauigkeit der optischen Komponenten nicht zufriedenstellend. Die geformten Substrate sind, wie zum Beispiel beim Glastiefziehen, aufgeraut und können die Anforderungen beispielsweise an ein optisches Fenster nicht erfüllen.

Beim Blankpressen sind die maximalen Ausdehnungen beziehungsweise Abmessungen der herstellbaren optischen Komponenten stark limitiert. Des Weiteren sind bei diesem Prägeverfahren sehr hochwertige, beständige und damit teure Prägewerkzeuge erforderlich, was eine flexible Fertigung einschränkt.

Beim Prozessschritt des Erwärmens und Verformens wird das erste Substrat, zumindest die Verformungsbereiche des ersten Substrats, bevorzugt auf eine Temperatur gebracht, die zwischen der Erweichungstemperatur minus 150°C und der Erweichungstemperatur plus 100°C des Materials der Verformungsbereiche, insbesondere zwischen etwa 750 °C und etwa 900 °C, liegt. Im Bereich der Erweichungstemperatur weist das Material der Verformungsbereiche besonders günstige Verformungseigenschaften, insbesondere bezüglich Viskosität, auf. Anschließend oder bereits während des Erwärmungsprozesses wird das erste Substrat durch eine Kraft beziehungsweise Kraftwirkung auf den Auslenkungsbereich in den Verformungsbereichen verformt.

Bei Verwendung von Borsilikatglas, mit einer Erweichungstemperatur von etwa 820 °C, sind beispielsweise Temperaturen zwischen etwa 750 °C und etwa 900 °C zweckmäßig.

Die Erweichungstemperatur oder Erweichungspunkt (softening point), auch Littletontemperatur oder Littleton-Punkt genannt, wird nach einer Methode von Littleton bestimmt. Dabei wird ein Materialfaden (zum Beispiel ein Glasfaden) mit einem Durchmesser von 0,65 mm bis 1,0 mm und einer Länge von 22,9 cm in einen Ofen bestimmter Konstruktion gehängt. Bei einer Aufheizgeschwindigkeit von 5 bis 10 K/min beobachtet man das aus dem Ofen heraushängende untere Ende des Fadens. Mit steigender Temperatur verlängert sich der Faden unter dem eigenen Gewicht. Die Temperatur, bei der die Verlängerung 1 mm/min beträgt, wird als Littletontempertur bezeichnet. Die meisten Gläser oder glasähnlichen Materialien weisen bei dieser Temperatur eine Viskosität von etwa 10^{-7.6} dPa·s auf (Scholze, Horst "Glas - Natur, Struktur und Eigenschaften", 3. Auflage, Springer Verlag, S. 151).

Der Prozessschritt des Erwärmens und Verformens wird bevorzugt zeitgesteuert oder bis zum Kontakt des ersten Substrats und/oder der Verstärkungselemente mit einer Auslenkungsbegrenzung, die beispielsweise die maximal gewünschte verformungsgedingte Auslenkung begrenzt, durchgeführt. Als Auslenkungsbegrenzung kann zum Beispiel das mindestens eine zweite Substrat, insbesondere die Bodenflächen der dritten Vertiefungen, dienen.

Die Verformung des ersten Substrats beziehungsweise der Verformungsbereiche kann bevorzugt durch die Eigengewichtskraft der Verstärkungselemente und der von ihnen abgedeckten Bereiche des ersten Substrats und/oder durch eine von außen eingebrachte Kraft bedingt werden.

Eine von außen eingebrachte Kraft kann zweckmäßigerweise auf einer mechanischen und/oder magnetischen und/oder elektrischen und/oder piezoelektrischen Wechselwirkung beruhen.

In einer bevorzugten Ausführungsform wird die von außen eingebrachte Kraft durch eine Druckdifferenz zwischen beiden Substratseiten des ersten Substrats, insbesondere im Auslenkungsbereich, bewirkt. Wie bei der Verformung durch die Eigengewichtskraft muss auch bei dieser Methode der Krafteinbringunng der Stapel, insbesondere das erste Substrat, nicht mit einem weiteren Gegenstand in Kontakt gebracht werden, wodurch eine Qualitätsminderung der Oberflächen des ersten Substrats, beispielsweise durch ein Prägewerkzeug, verhindert wird.

Zudem kann in diesem Fall der Prozessschritt des Erwärmens und Verformens so lange durchgeführt werden, bis eine durch die Formgebung des ersten Substrats bedingte Volumenänderung der Hohlräume zu demselben Druck in den Hohlräumen wie dem Umgebungsdruck geführt hat.

Auch speziell gestaltete Formgebungsvorrichtungen eignen sich für das Einbringen einer Kraft.

Die eingebrachte Kraft kann sowohl zentrisch als auch nicht zentrisch in Bezug auf die Verstärkungselemente und/oder den Auslenkungsbereich wirken.

Aus einem zum Beispiel über den Auslenkungsbereichen gleichverteilten Kraftprofil resultiert eine in Bezug auf den Auslenkungsbereich zentrische Kraft, wodurch bei zentrischer Anordnung der Verstärkungselemente in den Auslenkungsbereichen ein Verschieben der abgedeckten Bereiche des ersten Substrats erreicht werden kann. Ein Neigen der durch die Verstärkungselemente abgedeckten Bereiche des ersten Substrats kann in diesem Fall durch eine nicht zentrische Anordnung der Verstärkungselemente in den Auslenkungsbereichen erzielt werden (Fig. 3d).

Bei einer zentrischen Anordnung der Verstärkungselemente in den Auslenkungsbereichen kann ein Neigen der durch die Verstärkungselemente abgedeckten Bereiche des ersten Substrats durch eine in Bezug auf die Verstärkungselemente nicht zentrische Kraft erreicht werden. Besonders vorteilhaft und effektiv zur Gewährleistung einer Neigung ist eine sowohl nicht zentrische Anordnung der Verstärkungselemente als auch eine in Bezug auf die Verstärkungselemente nicht zentrische Kraft.

Um ein möglichst problemloses verformungsbedingtes Auslenken gewährleisten zu können, sollte der Stapel in den Auslenkungsbereichen vor dem Verformen möglichst keinen Kontakt zu dem mindestens einen zweiten Substrat aufweisen. Ein Kontakt könnte durch Haft- beziehungsweise Kontaktkräfte bedingt ein verformungsgedingtes Auslenken des ersten Substrats erschweren oder sogar verhindern. Bevorzugt werden die Oberflächen der Verstärkungselemente, des ersten Substrats und/oder des zweiten Substrats in den Auslenkungsbereichen derart präpariert, dass eine Verbindung zwischen dem Stapel und dem zweiten Substrat in den Auslenkungsbereichen verhindert wird. Dies lässt sich durch verschiedene Beschichtungen und/oder Verfahren zur Oberflächenmodifikation realisieren, die zur Reduktion der Kontaktkräfte beitragen. Geeignete Beschichtungsmaterialien sind beispielsweise Platin, NiAl-Legierung (zum Beispiel Legierung aus 50% Ni und 50% Al), Graphit und Bornitrid.

Insbesondere wenn die mindestens eine Schicht beziehungsweise die Verstärkungselemente und/oder Auflagestrukturen und/oder Fixierungselemente keine weiteren Funktionen zu erfüllen haben, werden diese bevorzugt in einem weiteren Verfahrensschritt zumindest teilweise entfernt. Für bestimmte Anwendungen kann es allerdings von Vorteil sein, dass Teile der Verstärkungselemente, zum Beispiel als rahmenförmige Stabilisierungsstruktur oder Blendenstruktur, auf dem ersten Substrat beziehungsweise der fertigen optischen Komponente verbleiben.

Auch das mindestens eine zweite Substrat wird nach dem Verformen bevorzugt komplett entfernt. In manchen Fällen sind auf dem zweiten Substrat allerdings die zu verkapselnden Mikro-Systeme angeordnet, so dass ein Bestehen bleiben der Verbindung zwischen Stapel und dem zweiten Substrat durchaus sinnvoll sein kann.

In einer vorteilhaften Ausgestaltung werden zumindest Teilbereiche des ersten Substrats mit mindestens einer Veredlungsbeschichtung - insbesondere mit einer Entspiegelungsbeschichtung, einer Antistatik-Beschichtung, einer Reflexionsbeschichtung und/oder einer Absorbtionsbeschichtung, und/oder funktionalen Oberflächenstrukturen versehen, wodurch sich die Funktionalität der optischen Komponenten verbessern lässt. Bezüglich Veredlungsbeschichtung und funktionalen Oberflächenstrukturen wird auf das bereits zum erfindungsgemäßen Deckel ausgeführte verwiesen.

Mottenaugenstrukturen lassen sich beispielsweise mit Hilfe von Prägeverfahren nach der Formgebung des ersten Substrats auf den Oberflächen des ersten Substrats, insbesondere im Bereich der optischen Fenster, erzeugen. Das Einprägen solcher Stukturen in geneigte und/oder verschobene Oberflächen ist allerdings äußerst problematisch. Insbesondere auf geneigten Oberflächen lassen sich Mottenaugenstrukturen durch die Ausnutzung der Fließeigenschaften des ersten Substrats herstellen.

Entsprechend werden in einer bevorzugten Ausführungsform Mottenaugenstrukturen als funktionale Oberflächenstrukturen derart erzeugt, dass vor dem Aufbringen der mindestens einen Schicht auf das erste Substrat zumindest die Seite der mindestens einen Schicht, die mit dem ersten Substrat in Verbindung gebracht wird, mit einer Negativform der Mottenaugenstrukturen versehen wird und nach dem Aufbringen der mindestens einen Schicht auf dem ersten Substrat während der Formgebung des ersten Substrats die Mottenaugenstrukturen auf der ersten und/oder zweiten Substratseite des ersten Substrats erzeugt werden, indem die Negativform in der mindestens einen Schicht auf die erste und/oder zweite Substratseite des ersten Substrats, insbesondere auf die Transmissionsflächen der optischen Fenster, abgeformt wird. Dabei fließt das erste Substrat in die durch die Negativform in der mindestens einen Schicht vorgegebenen Hohlformen, wodurch die entsprechende Oberflächengeometrie entsteht. Die Formgebung des ersten Substrats und die Erzeugung der Mottenaugenstrukturen können auch zeitlich separiert beziehungsweise nacheinander in unabhängigen Schritten erfolgen.

In einer weiteren bevorzugten Ausführungsform wird die Veredlungsbeschichtung derart erzeugt, dass vor dem Aufbringen der mindestens einen Schicht auf das erste Substrat zumindest die Seite der mindestens einen Schicht, die mit dem ersten Substrat in Verbindung gebracht wird, mit der Veredlungsbeschichtung versehen wird und anschließend die Verbindung zwischen dem ersten Substrat und der mindestens einen Schicht durch eine Verbindung zwischen der Veredlungsbeschichtung und dem ersten Substrat hergestellt wird oder dass vor dem Aufbringen der mindestens einen Schicht auf das erste Substrat die Veredlungsbeschichtung auf das erste Substrat und anschließend die mindestens eine Schicht auf die Veredlungsbeschichtung aufgebracht wird, wobei - nach Strukturierung der mindestens einen Schicht und der Veredlungsbeschichtung sowie dem Verformungsschritt - die mindestens eine Schicht, insbesondere das mindestens eine Verstärkungselement, entfernt wird und die Veredlungsbeschichtung auf dem ersten Substrat, insbesondere auf den optischen Fenstern, verbleibt. Mit dem Aufbringen der Veredlungsbeschichtung auf das erste Substrat vor der Verformung des ersten Substrats lässt sich insbesondere auf geneigten optischen Bereichen, wie zum Beispiel geneigten optischen Fenstern, eine homogene Veredlungsbeschichtung mit geringen Toleranzen in der Dicke der einzelnen Schichten der Veredlungsbeschichtung realisieren. Beim Aufbringen der Veredlungsbeschichtung nach der Verformung des ersten Substrats muss die Abscheidung und eine eventuelle Strukturierung der einzelnen Schichten zum Beispiel auf geneigten Bereichen beziehungsweise Oberflächen erfolgen, woraus insbesondere bei der Verwendung von anisotropen Abscheideverfahren Unterschiede in den Dicken der einzelnen Schichten und damit ortsabhängige Differenzen in den Eigenschaften beziehungsweise in der optischen Funktionalität der Veredlungsbeschichtung und damit der optischen Komponente resultieren können. Eine nach dieser Ausführungsform hergestellte Breitbandentspiegelungsbeschichtung könnte beispielsweise auf einer Schichtfolge aus Siliziumoxid und Siliziumnitrid basieren. In diesem Fall wird zuerst die Siliziumoxidschicht auf die mindestens eine Schicht, zum Beispiel ein Siliziumwafer, aufgebracht. Anschließend wird auf die Siliziumoxidschicht die Siliziumnitridschicht aufgebracht. Danach wird die Schichtfolge aus mindestens einer Schicht, Siliziumoxidschicht und Siliziumnitridschicht mit dem ersten Substrat verbunden, indem die Siliziumnitridschicht mit dem ersten Substrat in Verbindung gebracht wird. Nach selektiver Entfernung der mindestens einen Schicht bleibt eine Schichtfolge aus erstem Substrat, Siliziumnitridschicht und Siliziumoxidschicht und damit ein mit einer Entspiegelungsbeschichtung versehenes erstes Substrat bestehen.

Auch Kombinationen aus Veredlungsbeschichtung und funktionalen Oberflächenstrukturen, zum Beispiel einer Kombination aus Antistatik-Beschichtung und Mottenaugenstrukturen, können Verbesserungen der Funktionalität der optischen Komponente bewirken.

Der erfindungsgemäße Deckel wird bevorzugt für die Verkapselung von Mikro-Systemen auf Wafer-Ebene, insbesondere mittels Wafer-Level-Packaging-Verfahren, verwendet. Dadurch lassen sich mehrere Mikro-Systeme gleichzeitig verkapseln, wodurch ein zeitsparender und effektiver Verkapselungsprozess unterstützt wird.

Bevorzugt wird der erfindungsgemäße Deckel zur Verkapselung von Mikrospiegeln, insbesondere von beweglichen Mikrospiegeln, verwendet.

### Beispiele

Ohne Einschränkung der Allgemeinheit wird die Erfindung anhand von Beispielen nachfolgend näher beschrieben.

Fig. 2 zeigt erfindungsgemäße Deckel 22 mit geneigten optischen Fenstern 8 und verschobenen optischen Fenstern 30 und deren Verwendung zur Verkapselung eines Mikrospiegels 25.

Fig. 3 zeigt die Schrittfolge einer ersten Prozessvariante zur Herstellung eines erfindungsgemäßen Deckels 22 mit geneigten optischen Fenstern 8 nach dem erfindungsgemäßen Verfahren.

Fig. 4 zeigt die Schrittfolge einer zweiten Prozessvariante zur Herstellung eines erfindungsgemäßen Deckels 22 mit geneigten optischen Fenstern 8 nach dem erfindungsgemäßen Verfahren unter Verwendung von Auflagestrukturen 13.

Fig. 5 zeigt die Schrittfolge der zweiten Prozessvariante zur Herstellung eines erfindungsgemäßen Deckels 22 mit verschobenen optischen Fenstern 30 nach dem erfindungsgemäßen Verfahren.

Fig. 6 zeigt die Schrittfolge der zweiten Prozessvariante zur Herstellung eines erfindungsgemäßen Deckels 22 mit verschoben und geneigt ausgeführten optischen Fenstern 32 nach dem erfindungsgemäßen Verfahren.

Fig. 7 zeigt die Schrittfolge der zweiten Prozessvariante zur Herstellung eines erfindungsgemäßen Deckels 22 mit zwei geneigten optischen Fenstern 8 in einem Auslenkungsbereich 21 nach dem erfindungsgemäßen Verfahren.

Fig. 8 zeigt die Schrittfolge der zweiten Prozessvariante zur Herstellung eines erfindungsgemäßen Deckels 22 mit zwei geneigten 8 und einem verschobenen optischen Fenster 30 in einem Auslenkungsbereich 21 nach dem erfindungsgemäßen Verfahren.

Fig. 9 zeigt den Einsatz von Fixierungselementen 16.

Fig. 10 zeigt das Einbringen einer durch eine mechanische Wechselwirkung bedingten Kraft mittels Formgebungsvorrichtungen 18.

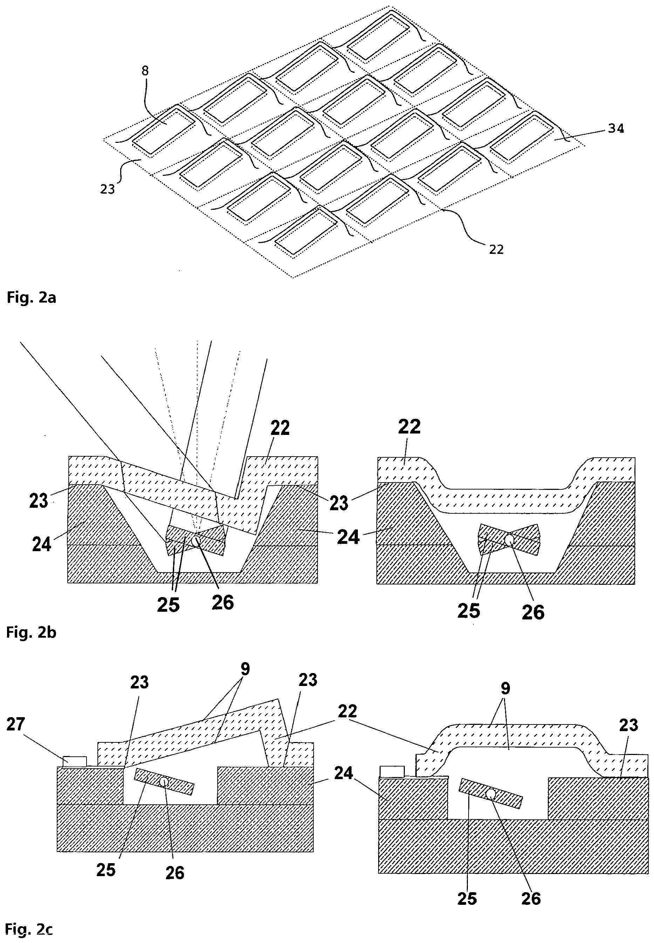

Fig. 2a zeigt einen erfindungsgemäßen Deckel 22 beziehungsweise den Ausschnitt eines nach dem erfindungsgemäßen Verfahren strukturierten beziehungsweise geformten Glaswafers, der zum Verkapseln eines gesamten Siliziumwafers verwendet werden kann. Den Ausgang bildet ein beidseitig ebener, planparallele Substratebenen 1a, 1b aufweisender Glaswafer 1 aus Borsilikatglas. Beide Waferseiten beziehungsweise Waferebenen 1a, 1b sind poliert ausgeführt, um eine geringe Oberflächenrauigkeit und damit eine hohe Qualität der geneigten optischen Fenster 8 zu gewährleisten. Die geneigten optischen Fenster 8 sind in einem zweidimensionalen Array angeordnet und weisen in Bezug auf die umlaufenden Kontaktflächen 23 üblicherweise eine Neigung zwischen etwa 5° und etwa 20°, bevorzugt etwa 15° auf. Die umlaufenden Kontaktflächen 23 sind um jedes geneigte optische Fenster 8 rahmenförmig geschlossen angeordnet und eben ausgeführt. Entsprechend dimensionierte rahmenförmig geschlossene ebene Flächen sind auf dem Trägersubstrat beziehungsweise Trägerwafer 24 als Gegenkontaktflächen vorgesehen, so dass eine zur Umgebung hermetisch dicht abschließende Verbindung ermöglicht wird.

Die geneigten optischen Fenster 8 sind beidseitig mit einer Entspiegelungsbeschichtung aus einem Schichtsystem aus Siliziumdioxid und Titanoxid versehen.

Die Fig. 2b und 2c zeigen jeweils zwei Verwendungsvarianten des erfindungsgemäßen Deckels 22 mit geneigtem optischen Fenster (8) und verschobenem optischen Fenster (30) zur Verkapselung eines Mikrospiegels 25.

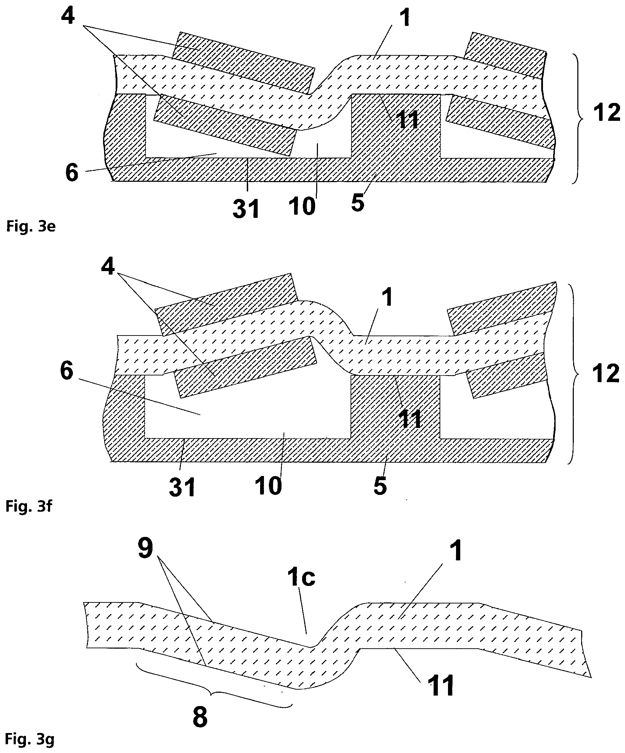

Fig. 3 zeigt die Schrittfolge einer ersten Prozessvariante zur Herstellung eines erfindungsgemäßen Deckels 22 nach dem erfindungsgemäßen Verfahren. Das zum Prozessbeginn bereitgestellte erste Substrat 1 ist ein beidseitig ebener, planparallele Substratebenen 1a, 1b aufweisender Glaswafer aus Borsilikatglas. Beide Waferseiten beziehungsweise Waferebenen 1a, 1b des Glaswafers 1 sind poliert und weisen damit eine hohe Oberflächenqualität mit geringer Rauigkeit auf.

Des Weiteren werden zwei Siliziumwafer 2 bereitgestellt, die auf der jeweils mit dem Glaswafer 1 in Verbindung zu bringenden Waferseite zweite Vertiefungen 3 (siehe Fig. 3a) aufweisen. Die zweiten Vertiefungen 3 sollen beim Verbinden von Glaswafer 1 und Siliziumwafern 2 in den Bereichen des Glaswafers 1, in denen keine Verstärkungselemente 4 vorgesehen sind, einen Kontakt zwischen Glaswafer 1 und Siliziumwafern 2 vermeiden, um diese Bereiche des Glaswafers 1 für weitere Verbindungs- und/oder Kontaktierungsschritte, zum Beispiel anodisches Bonden des Glaswafers 1 mit dem mindestens einen zweiten Substrat 5, zu konservieren. Die zweiten Vertiefungen 3 weisen Tiefen von etwa 0,7 µm auf.

Mittels anodischen Bondens wird je ein Siliziumwafer 2 mit je einer Substratseite 1a, 1b des Glaswafers 1 zu einem Stapel 7 verbunden, wie Fig. 3b zeigt.

Im anschließenden Strukturierungsprozess werden die beiden Siliziumwafer 2 des Stapels 7 durch nasschemische Ätzverfahren und/oder Trockenätzverfahren derart strukturiert, dass in den Bereichen des Glaswafers 1, die als geneigte optische Fenster 8 fungieren, Silizium als Verstärkungselemente 4 verbleibt (Fig. 3c). Im Ergebnis sind die einzelnen Verstärkungselemente 4 vollständig durch von Silizium befreite Bereiche des Glaswafers 1 umgeben beziehungsweise voneinander getrennt.

Im nächsten Verfahrensschritt wird als mindestens zweites Substrat 5 ein weiterer Siliziumwafer mit dritten Vertiefungen 6 bereitgestellt und mit dem strukturierten Stapel 7, insbesondere mit dem Glaswafer 1, durch anodisches Bonden zu einem Schichtsystem 12 verbunden. Dabei werden der Stapel 7 und der Siliziumwafer 5 so zueinander angeordnet, dass die dritten Vertiefungen 6 im Siliziumwafer 5 nach dem Verbinden mit dem Stapel 7 zur Umgebung hermetisch dicht abschließende

Hohlräume 10 zwischen dem Silizumwafer 5 und dem Stapel 7 bilden und die dem Siliziumwafer 5 zugewandten Verstärkungselemente 4 einschließen. Zudem sind die Verstärkungselemente 4 nicht zentrisch im Auslenkungsbereich 21 und damit zwischen den Auflageflächen 11 beziehungsweise Auflagebereichen 11a angeordnet. Ein Kontakt zwischen den Verstärkungselementen 4 und dem Siliziumwafer 5 besteht vor dem Erwärmen und Verformen nicht, wie Fig. 3d zeigt.

Das anodische Bonden erfolgt bei Temperaturen von etwa 400°C und einem Druck von etwa 600 mbar oder etwa 800 mbar.

Beim folgenden Prozessschritt wird das Schichtsystem 12 aus Siliziumwafer 5 und Stapel 7 zuerst erwärmt. Bei Verwendung eines Glaswafers 1 aus Borsilikatglas, mit einer Erweichungstemperatur von etwa 820 °C, wird das Schichtsystem 12 aus Siliziumwafer 5 und Stapel 7 auf etwa 800 °C erwärmt. Durch die im Vergleich zum Bondprozess erhöhte Temperatur steigt der Druck in den Hohlräumen 10 von etwa 600 mbar auf etwa 900 mbar oder von etwa 800 mbar auf etwa 1200 mbar. Der entsprechend herrschende Unterdruck oder Überdruck in Bezug auf den atmosphärischen Luftdruck der Umgebung führt zu einer das Glassubstrat 1 in die dritten Vertiefungen 6 des Siliziumwafers 5 hineinziehenden oder herausdrückenden Kraftwirkung, wodurch die durch die Verstärkungselemente 4 abgedeckten Bereiche des Glaswafer 1 geneigt werden, wie die Fig. 3e und 3f zeigen. Der Verformungsschritt wird bei Kontakt der Verstärkungselemente 4 am Boden 31 der dritten Vertiefungen 6 oder nachdem der Druck in den Hohlräumen 10 verformungsgedingt den Wert des Umgebungsdrucks erreicht hat abgebrochen.

Im letzten Schritt werden die Verstärkungselemente 4 und der Siliziumwafer 5 vom Glaswafer 1 nasschemisch selektiv entfernt (Fig. 3g).

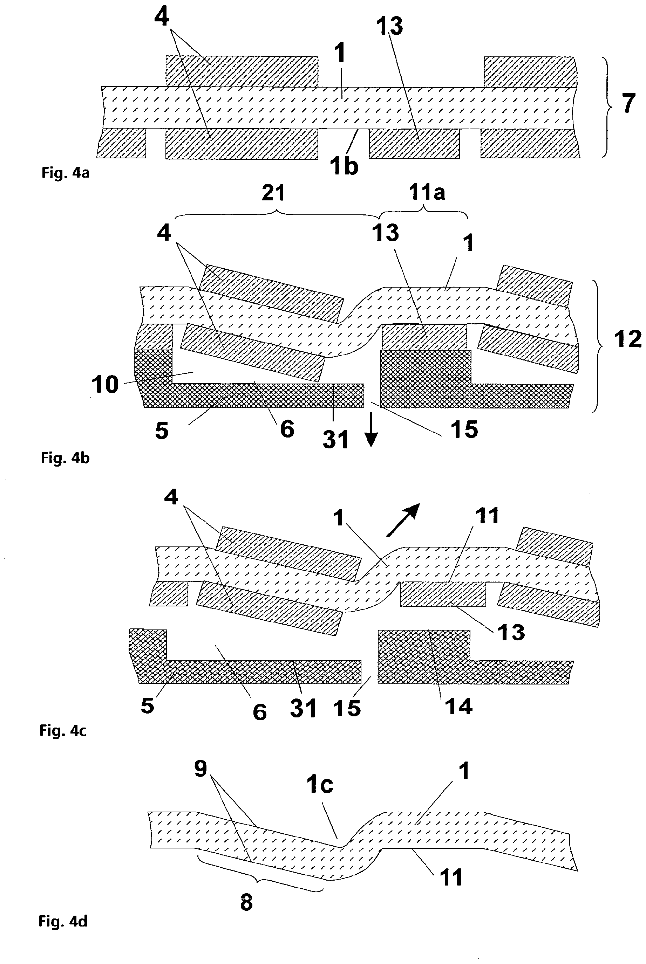

Fig. 4 zeigt eine zweite Prozessvariante zur Herstellung eines Deckels 22 nach dem erfindungsgemäßen Verfahren. Nach Bereitstellung eines Glaswafers 1 aus Borsilikatglas und zwei Siliziumwafern 2 wird, wie bei der vorher aufgezeigten Prozessvariante, mittels anodischen Bondens je ein Siliziumwafer 2 mit je einer Substratseite 1a, 1b des Glaswafers 1 zu einem Stapel 7 verbunden.

Im anschließenden Strukturierungsprozess werden die beiden Siliziumwafer 2 des Stapels 7 durch nasschemische Ätzverfahren und/oder Trockenätzverfahren derart strukturiert, dass in den Bereichen des Glaswafers 1, die als geneigte optische Fenster 8 fungieren, und in den Bereichen des Glaswafers 1, die als Auflageflächen 11 beziehungsweise Auflagebereiche 11a vorgesehen sind, Silizium als Verstärkungselemente 4 und als Auflagestrukturen 13 verbleibt (Fig. 4a). Die Auflagestrukturen 13 bilden dabei einen geschlossenen Rahmen um ein auf derselben Substratseite 1b des Glaswafers 1 befindliches Verstärkungselement 4 und dienen als Schutz der Auflageflächen 11 des Glaswafers 1 beim Kontakt des Stapels 7 mit dem mindestens einen zweiten Substrat 5. Durch diesen Schutz wird ein direkter Kontakt zwischen Glaswafer 1 und mindestens einen zweiten Substrat 5 vermieden, wodurch die hohe Ebenheit und die geringe Rauigkeit der Auflageflächen 11 unabhängig von der Oberflächenqualität des mindestens einen zweiten Substrats 5 erhalten werden kann. Die Verstärkungselemente 4 sind wiederum nicht zentrisch zwischen den Auflageflächen 11 beziehungsweise Auflagestrukturen 13 angeordnet.

Als mindestens zweites Substrat 5 wird ein Substrat beziehungsweise Werkzeug verwendet, das dritte Vertiefungen 6 aufweist und zudem aus Graphit besteht oder zumindest dessen Gegenkontaktflächen 14, die für den Kontakt mit dem Stapel 7 vorgesehen sind, mit Graphit beschichtet sind. Zudem weist dieses Graphit aufweisende mindestens eine zweite Substrat 5 Kanäle 15 auf, die den Anschluss einer externen Vakuumpumpe gewährleisten.

Im nächsten Verfahrensschritt werden die Auflagestrukturen 13 des Stapels 7 und das Graphit aufweisende mindestens eine zweite Substrat 5 derart miteinander in Kontakt gebracht, dass die dritten Vertiefungen 6 im zweiten Substrat 5 nach dem in Kontakt bringen mit dem Stapel 7 zur Umgebung abschließende Hohlräume 10 zwischen dem zweiten Substrat 5 und dem Stapel 7 bilden, wobei die Hohlräume 10 die Verstärkungselemente 4, die dem zweiten Substrat 5 zugewandt sind, einschließen und nicht zur Umgebung hermetisch dicht abgeschlossen sein müssen. Über die Kanäle 15 wird mittels externer Vakuumpumpe ein Unterdruck in den Hohlräumen 10 erzeugt (Fig. 4b).

Der nachfolgende Erwärmungs- und Verformungsschritt wird, wie bei der vorherigen Prozessvariante beschrieben, durchgeführt.

Im Anschluss wird in den Hohlräumen 10 wieder atmosphärischer Luftdruck (Umgebungsdruck) eingestellt. Dadurch lässt sich der Stapel 7 vom zweiten Substrat 5 abheben beziehungsweise trennen, wie Fig. 4c zeigt.

Im abschließenden Prozessschritt werden die Verstärkungselemente 4 und die Auflagestrukturen 13 durch nasschemisches selektives Ätzen vom Glaswafer 1 entfernt (Fig. 4d).

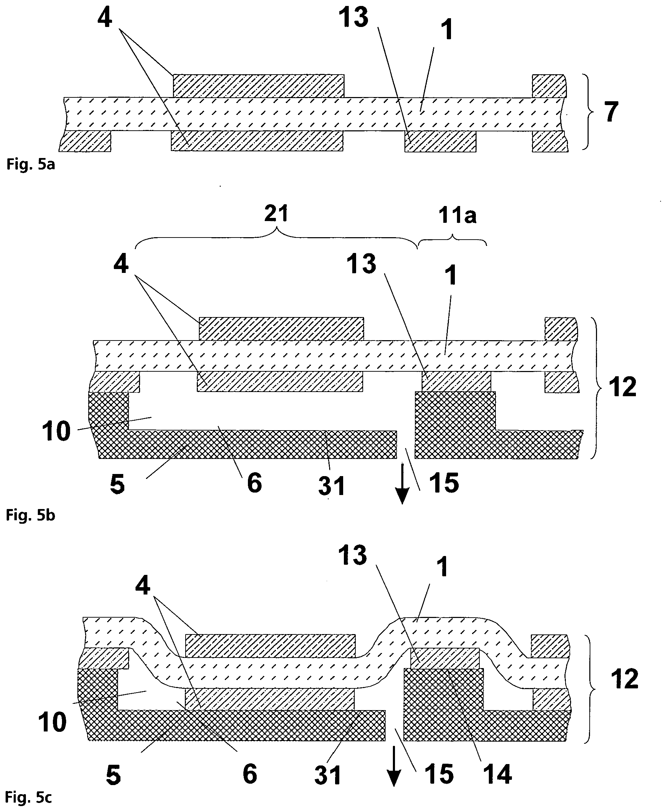

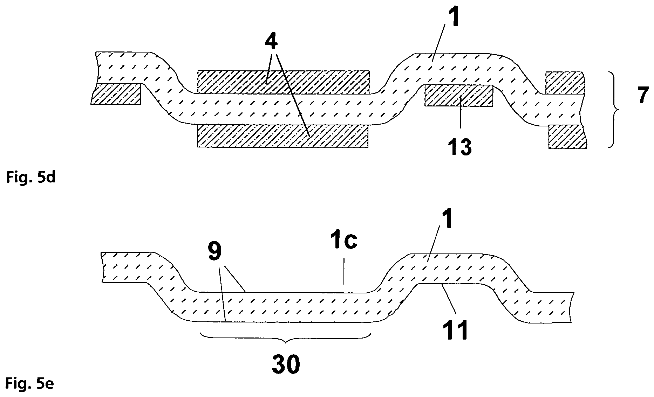

In Fig. 5a-5d wird gezeigt, wie sich mit dem erfindungsgemäßen Verfahren nach der vorher beschriebenen zweiten Prozessvariante ein erfindungsgemäßer Deckel 22 mit verschoben ausgeführten optischen Fenstern (verschobenen optischen Fenstern) 30 herstellen lässt.

Wie oben beschrieben, wird für das mindestens eine zweite Substrat 5 ein Substrat beziehungsweise Werkzeug verwendet, das dritte Vertiefungen 6 aufweist. Ein Verschieben beziehungsweise ein aus den Substratebenen 1a, 1b Parallelverschieben der durch die Verstärkungselemente 4 abgedeckten Bereiche des ersten Substrats 1 wird durch eine zentrische Anordnung der Verstärkungselemente 4 in den Auslenkungsbereichen 21 unterstützt. Der Verformungsschritt kann so lange erfolgen, bis die Verstärkungselemente 4 auf dem Boden 31 der dritten Vertiefungen 6 des mindestens einen zweiten Substrats 5 aufliegen.

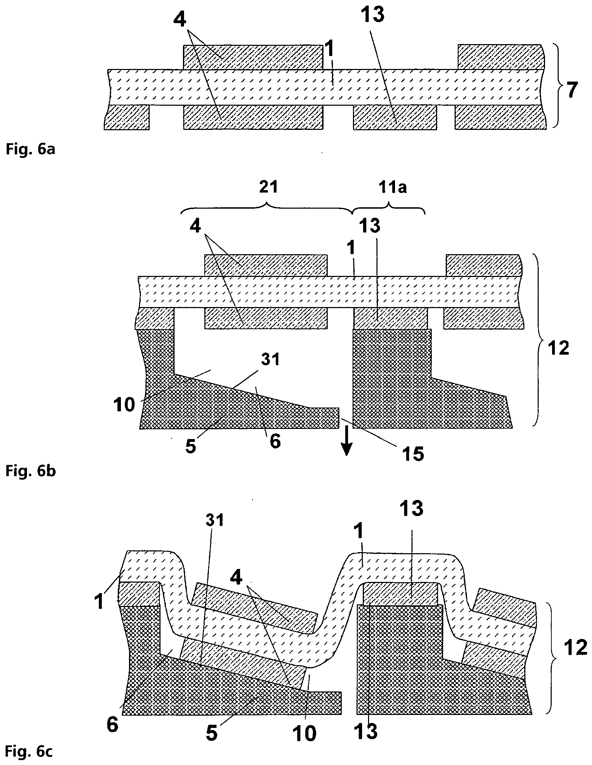

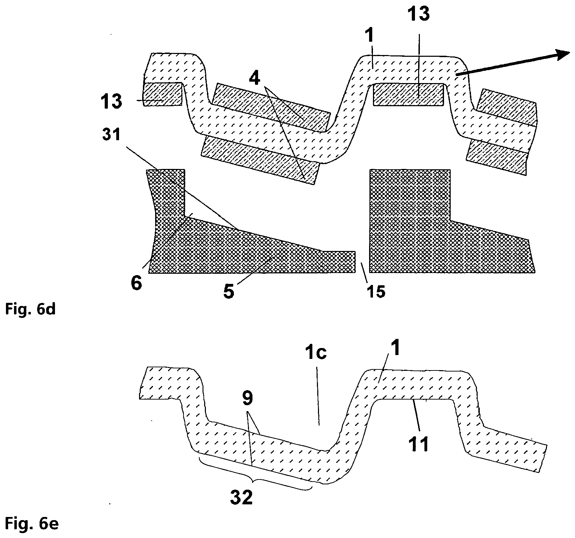

Durch eine zumindest in Teilbereichen geneigte Ausführung der Böden 31 der dritten Vertiefungen 6 und/oder eine nicht zentrische Anordnung der Verstärkungselemente 4 in den Auslenkungsbereichen 21 lässt sich ein erfindungsgemäßer Deckel 22 mit verschoben und geneigt ausgeführten optischen Fenstern 32 herstellen, wie in Fig. 6a-6d gezeigt wird.

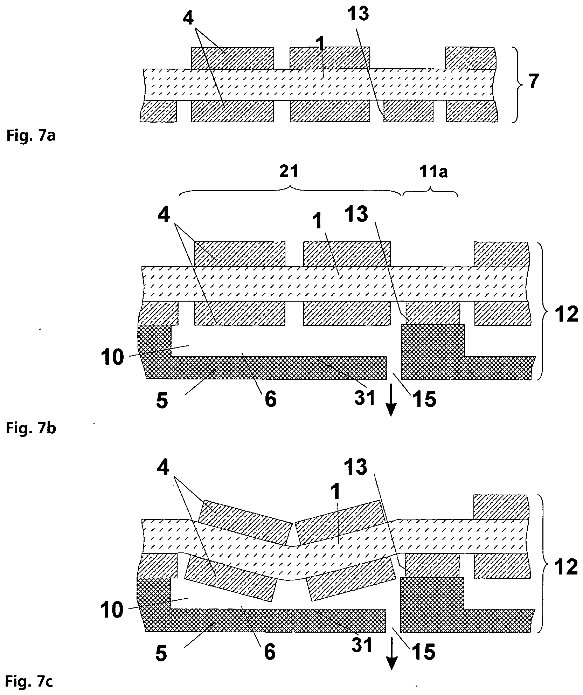

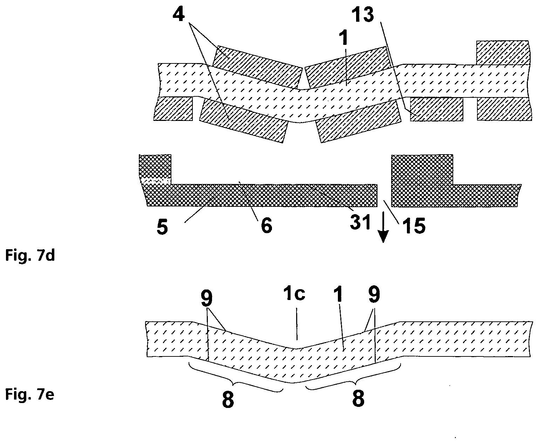

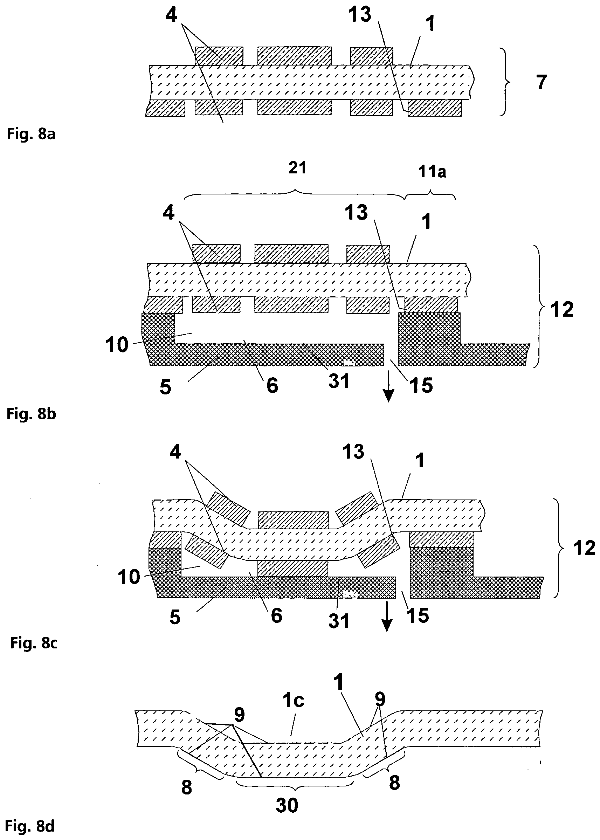

Weitere Modifikationen der zweiten Prozessvariante zur Herstellung eines erfindungsgemäßen Deckels 22 nach dem erfindungsgemäßen Verfahren sind in den Fig. 7 und 8 dargestellt.

Durch entsprechende Strukturierung der zwei Siliziumwafer 2 (Fig. 7a, Fig. 8a) lässt sich eine laterale Anordnung von mehreren Verstärkungselementen 4 in einem Auslenkungsbereich 21 (Fig. 7b, Fig. 8b) realisieren. Daraus resultieren im anschließenden Erwärmungs- und Verformungsschritt mehrere verschobene und/oder geneigte Bereiche beziehungsweise optische Fenster 8, 30 des Glaswafers 1 in einem Auslenkungsbereich 21 (Fig. 7c, Fig. 8c). Abschließend werden die Verstärkungselemente 4 und Auflagestrukturen 13 durch nasschemisches selektives Ätzen vom Glaswafer 1 entfernt (Fig. 7d, Fig. 8d).

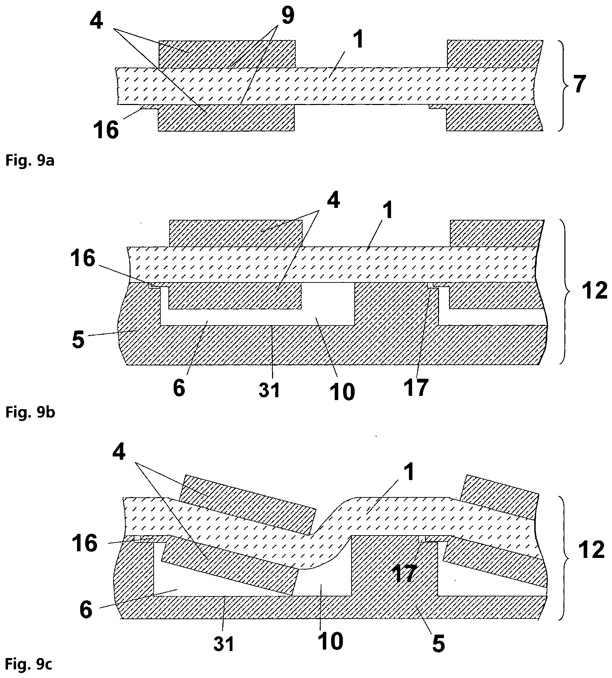

Fig. 9 zeigt den Einsatz von Fixierungselementen 16 bei der Herstellung eines erfindungsgemäßen Deckels 22 nach dem erfindungsgemäßen Verfahren. Wie man der Fig. 9a entnehmen kann, können die Fixierungselemente 16 bei der Strukturierung der mit dem ersten Substrat beziehungsweise dem Glaswafer 1 verbundenen und für die Erzeugung der Verstärkungselemente 4 vorgesehenen Siliziumwafern 2 erzeugt werden. Beim darauffolgenden anodischen Bonden von Stapel 7 und dem mindestens einen zweiten Substrat 5, hier einem Siliziumwafer, werden die Fixierungselemente 16 zwischen den zu verbindenden Flächen geklemmt und damit fixiert. Um trotz der Fixierungselemente 16 eine stabile Verbindung gewährleisten zu können, ist das mindestens eine zweite Substrat 5 mit Aufnahmenuten 17 für die Fixierungselemente 16 ausgelegt (Fig. 9b).

Beim anschließenden Erwärmungs- und Verformungsschritt verhindern die geklemmten Fixierungselemente 16 ein Verschieben und/oder Verdrehen der Verstärkungselemente 4. Zudem reduzieren die Fixierungselemente 16 unerwünschte Verformungen, zum Beispiel Durchwölbungen, in den durch die Fixierungselemente 16 abgedeckten Bereichen des Glaswafers 1 (Fig. 9c).

Bei den vorher genannten Prozessvarianten wird die Verformung des Glaswafers 1 durch eine Kraft, die aus einer Druckdifferenz zwischen Umgebungsdruck und dem in den durch den Stapel 7 und dem mindestens einen zweiten Substrat 5 eingeschlossenen Hohlräumen 10 vorherrschenden Druck resultiert, unterstützt.

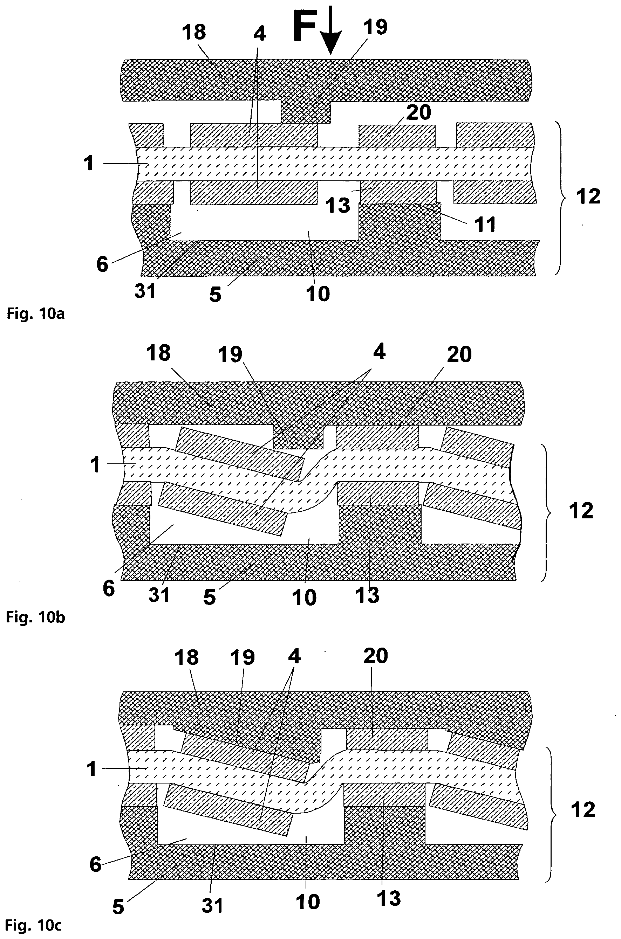

In einer weiteren Prozessvariante wird diese Kraft durch eine Formgebungsvorrichtung 18 mit einem Stempelelement 19 eingebracht. Dabei wird das Stempelelement 19 so ausgerichtet, dass die Kraft nicht zentrisch in Bezug auf die Verstärkungselemente 4 wirkt (Fig. 10a). Dadurch wird ein Neigen der Verstärkungselemente 4 und der von ihnen abgedeckten Bereiche des Glaswafers 1 begünstigt. Die Kraft wird aufrechterhalten, bis die gewünschte Neigung der durch die Verstärkungselemente 4 abgedeckten Bereiche des Glaswafers 1 erreicht ist.

Zur Erhöhung der Genauigkeit der Neigung der geneigten optischen Fenster 8 werden spezielle Anschlagstrukturen 20, die die maximale Auslenkung des Stempelelements 19 begrenzen, auf dem Glaswafer 1 aufgebracht beziehungsweise angeordnet. Diese Anschlagstrukturen 20 können in Form von Schichten oder Schichtfolgen auf dem Glaswafer 1 aufgebracht werden. Durch die Variation der Dicke der Schichten oder Schichtfolgen lässt sich die maximale Auslenkung des Stempelelements 19 und damit die gewünschte Neigung einstellen, da der Formgebungsprozess abgebrochen wird, sobald die Formgebungsvorrichtung 18 in Kontakt mit einer Anschlagstruktur 20 kommt, wie in Fig. 10b dargestellt ist.

Die Anschlagstrukturen 20 lassen sich beispielsweise in demselben Verfahrensschritt wie die Verstärkungselemente 4 durch die Strukturierung der mindestens einen Schicht 2 und/oder in einem oder mehreren zusätzlichen Verfahrensschritt/en erzeugen.

Eine weitere Erhöhung der Genauigkeit des Formgebungsprozesses lässt sich durch ein Stempelelement 19 erreichen, das über eine geneigte Stempelfläche (Fig. 10c), die die für die optischen Fenster 8 gewünschte Neigung aufweist, verfügt.

Die Formgebungsvorrichtung 18 kann so ausgelegt sein, dass sie mehrfach eingesetzt werden kann; indem zum Beispiel ein direkter Kontakt der Formgebungsvorrichtung 18 mit dem Glaswafer 1 vermieden wird.

### Bezugszeichenliste

- 1: erstes Substrat z.B. Glaswafer
- 1a: erste Substratebene beziehungsweise Substratseite des ersten Substrats
- 1b: zweite Substratebene beziehungsweise Substratseite des ersten Substrats
- 1c: erste Vertiefung im ersten Substrat
- 2: mindestens eine Schicht z.B. Siliziumwafer
- 3: zweite Vertiefung in der mindestens einen Schicht
- 4: Verstärkungselement
- 5: mindestens eine zweite Substrat z.B. Siliziumwafer
- 6: dritte Vertiefung im mindestens einen zweiten Substrat
- 7: Stapel
- 8: geneigtes optisches Fenster
- 9: Transmissionsfläche des optischen Fensters
- 10: Hohlraum zwischen Stapel und mindestens einen zweiten Substrat
- 11: Auflageflächen
- 11a: Auflagebereiche
- 12: Schichtsystem aus Stapel und mindestens einen zweiten Substrat
- 13: Auflagestruktur
- 14: Gegenkontaktfläche des mindestens einen zweiten Substrats
- 15: Kanal im mindestens einen zweiten Substrat
- 16: Fixierungselement
- 17: Aufnahmenut im mindestens einen zweiten Substrat
- 18: Formgebungsvorrichtung
- 19: Stempelelement z.B. mit gerader oder schräger Stempelfläche
- 20: Anschlagstruktur
- 21: Auslenkungsbereich
- 22: Deckel
- 23: Kontaktfläche des Deckels
- 24: Trägersubstrat
- 25: Mikrospiegel
- 26: Aufhängung des Mikrospiegels
- 27: Kontaktpad
- 28: einfallende Strahlung
- 29: abgelenkte Strahlung
- 30: verschobenes optisches Fenster
- 31: Boden der dritten Vertiefung im mindestens einen zweiten Substrat
- 32: verschoben und geneigt ausgeführtes optisches Fenster
- 33: Deckelbasisebene
- 34: Deckeleinheit

## Patentansprüche

1. Deckel für Mikro-Systeme, der einstückig ausgeführt ist und ein oder mehrere Deckeleinheiten (34) aufweist oder daraus besteht, wobei mindestens eine Deckeleinheit (34) mindestens eine durch Verformung bedingte erste Vertiefung (1c) aufweist, wobei die erste Vertiefung (1c) zumindest teilweise durch mindestens ein optisches Fenster (8, 30, 32), dessen quadratische Oberflächenrauigkeit kleiner gleich 25 nm ist, begrenzt ist.

2. Deckel nach Anspruch 1, **dadurch gekennzeichnet, dass** die quadratische Oberflächenrauigkeit des mindestens einen optischen Fensters (8, 30, 32) kleiner gleich 15 nm, bevorzugt kleiner gleich 5 nm ist.

3. Deckel nach einem der vorhergehenden Ansprüche, **dadurch gekennzeichnet, dass** der Deckel (22) zumindest in Teilbereichen Glas, bevorzugt ein Silikatglas, besonders bevorzugt Borsilikatglas, und/oder ein glasähnliches Material enthält oder daraus besteht.

4. Deckel nach einem der vorhergehenden Ansprüche, **dadurch gekennzeichnet, dass** die maximale Ausdehnung des Deckels (22) größer gleich 80 mm, insbesondere größer gleich 150 mm, ist.

5. Deckel nach einem der vorhergehenden Ansprüche, **dadurch gekennzeichnet, dass** die Transmissionsflächen (9) des mindestens einen optischen Fensters (8, 30, 32) eben und/oder zueinander planparallel ausgeführt sind.

6. Deckel nach Anspruch 5, **dadurch gekennzeichnet, dass** die Transmissionsflächen (9) eine Ebenheits- und/oder Planparallelitätsabweichung kleiner einem Viertel der Wellenlänge der in der Anwendung eingesetzten elektromagnetischen Strahlung, bevorzugt kleiner gleich 180 nm, besonders bevorzugt kleiner gleich 110 nm, aufweisen.

7. Deckel nach einem der vorhergehenden Ansprüche, **dadurch gekennzeichnet, dass** der Deckel (22) zumindest teilweise mit mindestens einer Veredlungsbeschichtung, insbesondere einer Entspiegelungsbeschichtung, einer Absorbtionsbeschichtung, einer Reflexionsbeschichtung und/oder einer Antistatik-Beschichtung, und/oder funktionalen. Oberflächenstrukturen, insbesondere Mottenaugenstrukturen, versehen ist.

8. Verfahren zur Herstellung optischer Komponenten mit den folgenden Schritten:
- Bereitstellen eines ersten Substrats (1),
- Erzeugen eines Stapels (7) durch Aufbringen mindestens einer Schicht (2) auf das erste Substrat (1),
- Strukturierung der mindestens einen Schicht (2) zur Erzeugung von mindestens einem Verstärkungselement (4),
- Bereitstellen mindestens eines zweiten Substrats (5),
- in Kontakt bringen des mindestens einen zweiten Substrats (5) mit dem Stapel (7),
- Erwärmen und Verformen des ersten Substrats (1) derart, dass sich mindestens ein durch das mindestens eine Verstärkungselement (4) abgedeckter Bereich des ersten Substrats (1) verschiebt und/oder neigt.

9. Verfahren nach Anspruch 8, **dadurch gekennzeichnet, dass** das erste Substrat (1) zumindest in Teilbereichen Glas, bevorzugt ein Silikatglas, besonders bevorzugt Borsilikatglas, und/oder ein glasähnliches Material enthält oder daraus besteht

10. Verfahren nach einem der Ansprüche 8 bis 9, **dadurch gekennzeichnet, dass** die mindestens eine Schicht (2) zumindest auf der Schichtseite, die mit dem ersten Substrat (1) in Verbindung gebracht wird, mindestens eine zweite Vertiefung (3) aufweist.

11. Verfahren nach einem der Ansprüche 8 bis 10, **dadurch gekennzeichnet, dass** mindestens ein Fixierungselement (16) erzeugt wird, das nach dem in Kontakt bringen des Stapels (7) mit dem mindestens einen zweiten Substrat (5) ein Verschieben und/oder Verdrehen des mindestens einen Verstärkungselements (4) gegenüber dem ersten Substrat (1) reduziert oder verhindert.

12. Verfahren nach einem der Ansprüche 8 bis 11, **dadurch gekennzeichnet, dass** das erste Substrat (1) zumindest in Teilbereichen mit mindestens einer Veredlungsbeschichtung, insbesondere mit einer Entspiegelungsbeschichtung, einer Antistatik-Beschichtung, einer Reflexionsbeschichtung und/oder einer Absorbtionsbeschichtung, und/oder funktionalen Oberflächenstrukturen versehen wird.

13. Verfahren nach Anspruch 12, **dadurch gekennzeichnet, dass** als funktionale Oberflächenstrukturen Mottenaugenstrukturen derart erzeugt werden, dass vor dem Aufbringen der mindestens einen Schicht (2) auf das erste Substrat (1) zumindest die Seite der mindestens einen Schicht (2), die mit dem ersten Substrat (1) in Verbindung gebracht wird, mit einer Negativform der Mottenaugenstrukturen versehen wird und nach dem Aufbringen der mindestens einen Schicht (2) auf dem ersten Substrat (1) während der Formgebung des ersten Substrats (1) die Mottenaugenstrukturen auf der ersten und/oder zweiten Substratseite (1a, 1b) des ersten Substrats (1) erzeugt werden, indem die Negativform in der mindestens einen Schicht (2) auf die erste und/oder zweite Substratseite (1a, 1b) des ersten Substrats (1), insbesondere auf die Transmissionsflächen (9) der optischen Fenster (8, 30, 32), abgeformt wird.

14. Verfahren nach einem der Ansprüche 12 bis 13, **dadurch gekennzeichnet, dass** die Veredlungsbeschichtung derart erzeugt wird, dass vor dem Aufbringen der mindestens einen Schicht (2) auf das erste Substrat (1) zumindest die Seite der mindestens einen Schicht (2), die mit dem ersten Substrat (1) in Verbindung gebracht wird, mit der Veredlungsbeschichtung versehen wird und anschließend die Verbindung zwischen dem ersten Substrat (1) und der mindestens einen Schicht (2) durch eine Verbindung zwischen der Veredlungsbeschichtung und dem ersten Substrat (1) hergestellt wird oder dass vor dem Aufbringen der mindestens einen Schicht (2) auf das erste Substrat (1) die Veredlungsbeschichtung auf das erste Substrat (1) und anschließend die mindestens eine Schicht (2) auf die Veredlungsbeschichtung aufgebracht wird, wobei - nach Strukturierung der mindestens einen Schicht (2) und der Veredlungsbeschichtung sowie dem Verformungsschritt - die mindestens eine Schicht (2), insbesondere das mindestens eine Verstärkungselement (4), entfernt wird und die Veredlungsbeschichtung auf dem ersten Substrat (1), insbesondere auf den optischen Fenstern (8, 30, 32), verbleibt.

15. Verwendung des Deckels (22) nach den Ansprüchen 1 bis 7 zur Verkapselung von Mikrospiegeln (25), insbesondere beweglichen Mikrospiegeln (25) und/oder zur Verkapselung auf Wafer-Ebene.

## Claims

1. Cover for microsystems, said cover having an integral embodiment and having or consisting of one or more cover units (34), wherein at least one cover unit (34) has at least one first depression (1c) caused by a deformation, wherein the first depression (1c) is at least partly delimited by at least one optical window (8, 30, 32), the RMS surface roughness of which is less than or equal to 25 nm.

2. Cover according to Claim 1, **characterized in that** the RMS surface roughness of the at least one optical window (8, 30, 32) is less than or equal to 15 nm, preferably less than or equal to 5 nm.

3. Cover according to any one of the preceding claims, **characterized in that** the cover (22), at least in portions, contains or consists of glass, preferably a silicate glass, particularly preferably borosilicate glass, and/or a glass-like material.

4. Cover according to any one of the preceding claims, **characterized in that** the maximum extent of the cover (22) is greater than or equal to 80 mm, in particular greater than or equal to 150 mm.

5. Cover according to any one of the preceding claims, **characterized in that** the transmission surfaces (9) of the at least one optical window (8, 30, 32) are embodied in planar fashion and/or aligned plane-parallel in relation to one another.

6. Cover according to Claim 5, **characterized in that** the transmission surfaces (9) have a deviation from planarity and/or plane-parallelism that is less than one quarter of the wavelength of the electromagnetic radiation used in application, preferably less than or equal to 180 nm, particularly preferably less than or equal to 110 nm.

7. Cover according to any one of the preceding claims, **characterized in that** the cover (22) is provided, at least in part, with at least one finishing coating, in particular an antireflection coating, an absorption coating, a reflection coating and/or an antistatic coating, and/or functional surface structures, in particular moth-eye structures.

8. Method for producing optical components, including the following steps:
- providing a first substrate (1),
- producing a stack (7) by applying at least one layer (2) to the first substrate (1),
- structuring the at least one layer (2) for producing at least one reinforcement element (4),
- providing at least one second substrate (5),
- bringing the at least one second substrate (5) into contact with the stack (7),
- heating and deforming the first substrate (1) in such a way that at least one region of the first substrate (1) that is covered by the at least one reinforcement element (4) is displaced and/or inclined.

9. Method according to Claim 8, **characterized in that** the first substrate (1), at least in portions, contains or consists of glass, preferably a silicate glass, particularly preferably borosilicate glass, and/or a glass-like material.

10. Method according to either of Claims 8 and 9, **characterized in that** the at least one layer (2) has at least one second depression (3), at least on the layer side that is connected to the first substrate (1) .

11. Method according to any one of Claims 8 to 10, **characterized in that** at least one fixation element (16) is produced, which reduces or prevents a displacement and/or rotation of the at least one reinforcement element (4) in relation to the first substrate (1) after the stack (7) has been brought into contact with the at least one second substrate (5) .

12. Method according to any one of Claims 8 to 11, **characterized in that** the first substrate (1) is provided, at least in portions, with at least one finishing coating, in particular with an antireflection coating, an antistatic coating, a reflection coating and/or an absorption coating, and/or functional surface structures.

13. Method according to Claim 12, **characterized in that** moth-eye structures are produced as functional surface structures in such a way that, prior to the application of the at least one layer (2) on the first substrate (1), at least the side of the at least one layer (2) that is joined to the first substrate (1) is provided a negative form of the moth-eye structures and, after the application of the at least one layer (2) on the first substrate (1), the moth-eye structures are produced on the first and/or second substrate side (1a, 1b) of the first substrate (1) during the shaping of the first substrate (1) by virtue of the negative form in the at least one layer (2) being moulded onto the first and/or second substrate side (1a, 1b) of the first substrate (1), in particular on the transmission surfaces (9) of the optical windows (8, 30, 32).

14. Method according to either of Claims 12 and 13, **characterized in that** the finishing coating is produced in such a way that, prior to the application of the at least one layer (2) on the first substrate (1), at least the side of the at least one layer (2) that is joined to the first substrate (1) is provided with the finishing coating and, subsequently, the connection between the first substrate (1) and the at least one layer (2) is produced by a connection between the finishing coating and the first substrate (1) or that, prior to the application of the at least one layer (2) on the first substrate (1), the finishing coating is applied to the first substrate (1) and the at least one layer (2) is subsequently applied to the finishing coating, wherein - after structuring the at least one layer (2) and the finishing coating and after the deformation step - the at least one layer (2), in particular the at least one reinforcement element (4), is removed and the finishing coating remains on the first substrate (1), in particular on the optical windows (8, 30, 32).

15. Use of the cover (22) according to Claims 1 to 7 for encapsulating micromirrors (25), in particular movable micromirrors (25), and/or for encapsulation on the wafer plane.

## Revendications

1. Couvercle pour microsystèmes, lequel est réalisé d'un seul tenant et possède une ou plusieurs unités de couvercle (34) ou s'en compose, au moins une unité de couvercle (34) possédant au moins une première empreinte (1c) due à une déformation, la première empreinte (1c) étant au moins partiellement délimitée par au moins une fenêtre optique (8, 30, 32) dont la rugosité de surface quadratique est inférieure ou égale à 25 nm.

2. Couvercle selon la revendication 1, **caractérisé en ce que** la rugosité de surface quadratique de l'au moins une fenêtre optique (8, 30, 32) est inférieure ou égale à 15 nm, de préférence inférieure ou égale à 5 nm.

3. Couvercle selon l'une des revendications précédentes, **caractérisé en ce que** le couvercle (22) contient ou se compose au moins dans des zones partielles du verre, de préférence un verre de silicate, notamment de préférence un verre de borosilicate et/ou un matériau similaire à du verre.

4. Couvercle selon l'une des revendications précédentes, **caractérisé en ce que** l'expansion maximale du couvercle (22) est égale ou supérieure à 80 mm, notamment égale ou supérieure à 150 mm.

5. Couvercle selon l'une des revendications précédentes, **caractérisé en ce que** les surfaces de transmission (9) de l'au moins une fenêtre optique (8, 30, 32) sont réalisées planes et/ou à plans parallèles l'une par rapport à l'autre.

6. Couvercle selon la revendication 5, **caractérisé en ce que** les surfaces de transmission (9) présentent un écart de planéité et/ou de parallélisme de plan inférieur à un quatre de la longueur d'onde du rayonnement électromagnétique utilisé dans l'application, de préférence inférieur ou égal à 180 nm, notamment préférence inférieur ou égal à 110 nm.

7. Couvercle selon l'une des revendications précédentes, **caractérisé en ce que** le couvercle (22) est au moins partiellement pourvu d'au moins un revêtement d'affinement, notamment un revêtement antireflet, un revêtement d'absorption, un revêtement de réflexion et/ou un revêtement antistatique et/ou de structures de surface fonctionnelles, notamment des structures en oeil de mite.

8. Procédé de fabrication de composants optiques, comprenant les étapes suivantes :
- fourniture d'un premier substrat (1),
- génération d'une pile (7) par application d'au moins une couche (2) sur le premier substrat (1),
- structuration de l'au moins une couche (2) en vue de générer au moins un élément de renforcement (4),
- fourniture d'au moins un deuxième substrat (5),
- mise en contact de l'au moins un deuxième substrat (5) avec la pile (7),
- réchauffement et façonnage du premier substrat (1) de telle sorte qu'au moins une zone du premier substrat (1) recouverte par l'au moins un élément de renforcement (4) se décale et/ou s'incline.

9. Procédé selon la revendication 8, **caractérisé en ce que** le premier substrat (1) contient ou se compose au moins dans des zones partielles du verre, de préférence un verre de silicate, notamment de préférence un verre de borosilicate et/ou un matériau similaire à du verre.

10. Procédé selon l'une des revendications 8 à 9, **caractérisé en ce que** l'au moins une couche (2) possède au moins une deuxième empreinte (3) au moins du côté de la couche qui est amenée en liaison avec le premier substrat (1).

11. Procédé selon l'une des revendications 8 à 11, **caractérisé en ce qu'**au moins un élément de fixation (16) est généré, lequel, après la mise en contact de la pile (7) avec l'au moins un deuxième substrat (5), réduit ou empêcher un décalage et/ou une torsion de l'au moins un élément de renforcement (4) par rapport au premier substrat (1).

12. Procédé selon l'une des revendications 8 à 11, **caractérisé en ce que** le premier substrat (1) est pourvu d'au moins un revêtement d'affinement au moins dans des zones partielles, notamment d'un revêtement antireflet, un revêtement antistatique, un revêtement de réflexion et/ou un revêtement d'absorption, et/ou de structures de surface fonctionnelles.

13. Procédé selon la revendication 12, **caractérisé en ce que** les structures de surface fonctionnelles sont des structures en oeil de mite générées de telle sorte qu'avant l'application de l'au moins une couche (2) sur le premier substrat (1), au moins le côté de l'au moins une couche (2), qui est amené en contact avec le premier substrat (1), est pourvu d'une forme négative des structures en oeil de mite et après l'application de l'au moins une couche (2) sur le premier substrat (1), pendant le façonnage du premier substrat (1), les structures en oeil de mite sont générées sur le premier et/ou le deuxième côté de substrat (1a, 1b) du premier substrat (1) en moulant la forme négative dans l'au moins une couche (2) sur le premier et/ou le deuxième côté de substrat (1a, 1b) du premier substrat (1), notamment sur les surfaces de transmission (9) de la fenêtre optique (8, 30, 32).

14. Procédé selon l'une des revendications 12 à 13, **caractérisé en ce que** le revêtement d'affinement est généré de telle sorte qu'avant l'application de l'au moins une couche (2) sur le premier substrat (1), au moins le côté de l'au moins une couche (2), qui est amené en contact avec le premier substrat (1), est pourvu du revêtement d'affinement, et ensuite la liaison entre le premier substrat (1) et l'au moins une couche (2) et établie par une liaison entre le revêtement d'affinement et le premier substrat (1), ou de telle sorte qu'avant l'application de l'au moins une couche (2) sur le premier substrat (1), le revêtement d'affinement est appliqué sur le premier substrat (1) et ensuite l'au moins une couche (2) est appliquée sur le revêtement d'affinement, et après la structuration de l'au moins une couche (2) et du revêtement d'affinement ainsi qu'après l'étape de façonnage, l'au moins une couche (2), notamment l'au moins un élément de renforcement (4), étant retiré et le revêtement d'affinement demeurant sur le premier substrat (1), notamment sur les fenêtres optiques (8, 30, 32).

15. Utilisation du couvercle (22) selon l'une des revendications 1 à 7 pour encapsuler les micromiroirs (25), notamment des micromiroirs (25) mobiles et/ou pour l'encapsulation au niveau d'une galette.
